# EUROPEAN PATENT SPECIFICATION

(11) **EP 2 775 623 B1**
(45) Date of publication and mention of the grant of the patent: **31.07.2019**
(21) Application number: 13192275.9
(22) Date of filing: 11.11.2013
(51) Int. Cl.: H03K 17/945, H03K 17/95

(54) **Electronic device and producing method thereof**
Elektronische Vorrichtung und Herstellungsverfahren dafür
Dispositif électronique et son procédé de production

(30) Priority: 08.03.2013 JP 2013046481; 03.10.2013 JP 2013208500
(43) Date of publication of application: 10.09.2014
(73) Proprietor: OMRON CORPORATION, Kyoto-shi, Kyoto 600-8530 (JP)
(72) Inventor: Nishikawa, Kazuyoshi, Kyoto-shi Kyoto 600-8530 (JP); Sanda, Takaaki, Kyoto-shi Kyoto 600-8530 (JP); Imabayashi, Tomonari, Kyoto-shi Kyoto 600-8530 (JP); Inoue, Daisuke, Kyoto-shi Kyoto 600-8530 (JP); Sugimoto, Makoto, Kyoto-shi Kyoto 600-8530 (JP); Kishimoto, Yukitaka, Kyoto-shi Kyoto 600-8530 (JP); Hiratsuka, Mikio, Kyoto-shi Kyoto 600-8530 (JP); Kameda, Takamasa, Kyoto-shi Kyoto 600-8530 (JP); Honjo, Takuya, Kyoto-shi Kyoto 600-8530 (JP); Hirao, Koichi, Kyoto-shi Kyoto 600-8530 (JP)
(74) Representative: Horn Kleimann Waitzhofer Patentanwälte PartG mbB

(56) References cited:
- EP-A1- 2 565 591
- DE-C1- 19 544 815
- GB-A- 2 328 284
- US-A- 6 025 562
- US-A1- 2001 038 883

## Description

### BACKGROUND OF THE INVENTION

### TECHNICAL FIELD

The present invention relates to an electronic device and a producing method thereof, particularly to an electronic device including a detection unit that detects the approach or presence of a detection target and a producing method thereof.

### RELATED ART

Japanese Unexamined Patent Application Publication No. 10-511716 discloses a molding product. The molding product is produced from a polyurethane hot-melt adhesive. The polyurethane hot-melt adhesive has a viscosity less than 100 Pa•s in a melting state at processing temperatures of 70 to 190°C.

Japanese Unexamined Patent Publication No. 09-092105 discloses a proximity sensor manufacturing method. The producing method includes a process of filling the proximity sensor with a primary filling resin with resin and a process of filling the proximity sensor with a secondary filling resin. A thermosetting resin is used as both the primary filling resin and the secondary filling resin.

Germany Patent Application Publication No. 19544815 discloses a sensor element. In the sensor element, the detection unit and electronic components are sealed by the thermosetting resin, and a connector or cable side is sealed by a thermoplastic resin.

In the case that a soft resin such as the polyurethane hot-melt disclosed in Japanese Unexamined Patent Application Publication No. 10-511716 is used as the sealing resin, there is generated a stress relaxation phenomenon that internal stress applied on the sealed member decreases with time. In the case that the detection unit is sealed using the hot-melt resin, a characteristic of the detection unit fluctuates easily due to the generation of the stress relaxation phenomenon.

In the disclosure of Japanese Unexamined Patent Publication No. 09-092105, as described above, the thermosetting resin is used as both the primary filling resin and the secondary filling resin. The thermosetting resin generates a shrinkage stress during curing. In the case that the electronic component mounted on a board is sealed using the thermosetting resin, it is necessary to perform a troublesome process of previously applying a silicone resin onto the electronic component to protect the electronic component from a curing shrinkage stress.

US 6 025 562 A describes a proximity sensor having a groove for discharging air formed at a coil casing arranged at a front surface of the proximity sensor. An opening is formed at a clamp portion holding a code behind a metal casing. The proximity sensor is held at a low pressure, and resin is supplied through the opening at the clamp portion, whereby the casing can be filled with the resin in a short time.

EP 2 565 591 A1 describes a base body for a capacitive switch having a flat actuating surface for releasing the switch and a base unit, which is partially transparent. Abase plate has an axial projection at its inner face, where a board has recesses. The projections of the base plate are arranged in the recesses of the board. A light emitting diode is arranged on a side of the board facing away from the inner side of base plate of the base unit.

GB 2 328 284 A describes a sensor head composed of an axially magnetized, sleeve-shaped permanent magnet that surrounds a Hall-effect generator located on the edge of a finger-like section of a printed circuit board. The magnet is supported on a mandrel integrally formed with a low-pressure cast material on the printed circuit board to permit the position of the magnet to be adjusted prior to assembly into the generator.

### SUMMARY

The present invention has been devised to solve the problems described above, and an object thereof is to provide an electronic device that can stably detect the approach or presence of the detection target while relaxing the stress remaining in the electronic device after the sealing, and a producing method thereof.

In accordance with one aspect of the present invention, an electronic device includes: a detection unit configured to detect the approach or presence of a detection target; an electronic component that is electrically connected to the detection unit; a case member configured to accommodate the detection unit and the electronic component therein; and a sealing resin that is formed in the case member. In the electronic device, the sealing resin includes: a thermosetting resin portion that is formed in the case member so as to seal the detection unit; and a thermoplastic resin portion that is formed in a portion other than the thermosetting resin portion in the case member so as to seal the electronic component, the thermoplastic resin portion having a hardness (Shore D) of 60 or less.

Preferably the detection unit includes a coil in which a coil wire is wound around a spool body and a core body configured to accommodate the coil therein, and the thermosetting resin portion seals the coil and the core body. Preferably the electronic device further includes a coil case that is accommodated at one end of the case member. In the electronic device, preferably the core body is accommodated in the coil case, and the thermosetting resin portion is formed in the coil case.

Preferably the case member has a cylindrical shape in which an inner diameter is greater than or equal to 5 mm and accommodates an elongated board on which the electronic component is mounted, and the viscosity of the thermoplastic resin portion ranges from 500 mPa•s to 10000 mPa•s when being measured with a rheometer at a shearing speed of 10 (1/s) and at a temperature of 190°C.

Preferably, the viscosity of the thermoplastic resin portion ranges from 500 mPa•s to 8000 mPa•s when being measured with the rheometer at a shearing speed of 10 (1/s) and at a temperature of 190°C.

In accordance with another aspect of the present invention, an electronic device producing method includes the steps of: disposing a detection unit and an electronic component in a case member, the detection unit being configured to detect the approach or presence of a detection target, the electronic component being electrically connected to the detection unit; forming a thermosetting resin portion such that the detection unit is sealed in the case member; and forming a thermoplastic resin portion having a hardness (Shore D) of 60 or less in a portion other than the thermosetting resin portion in the case member so as to seal the electronic component.

According to the present invention, the electronic device that can stably detect the approach or presence of the detection target while relaxing the stress remaining in the electronic device after the sealing, and the producing method thereof can be obtained.

### BRIEF DESCRIPTION OF THE DRAWINGS

Fig. 1 is a perspective view illustrating a proximity sensor according to a first embodiment;
Fig. 2 is an exploded perspective view illustrating the proximity sensor of the first embodiment;
Fig. 3 is a sectional view taken on a line III-III in Fig. 1;
Fig. 4 is a sectional view taken on a line IV-IV in Fig. 1;
Fig. 5 is an enlarged sectional view illustrating a neighborhood of a detection coil unit included in the proximity sensor of the first embodiment;
Fig. 6 is a perspective view schematically illustrating an internal structure of the detection coil unit included in the proximity sensor of the first embodiment;
Fig. 7 is a perspective view illustrating a front cover included in the proximity sensor of the first embodiment;
Fig. 8 is a view illustrating the front cover when the front cover is viewed in a direction indicated by an arrow VIII in Fig. 7;
Fig. 9 is a view illustrating the front cover when the front cover is viewed in a direction indicated by an arrow IX in Fig. 7;
Fig. 10 is a view illustrating the front cover when the front cover is viewed in a direction indicated by an arrow X in Fig. 7;
Fig. 11 is a view illustrating the front cover when the front cover is viewed in a direction indicated by an arrow XI in Fig. 7;
Fig. 12 is a perspective view illustrating a front end portion of the proximity sensor of the first embodiment;
Fig. 13 is an enlarged sectional view illustrating a range surrounded by an alternate long and two short dashes line XIII in Fig. 3;
Fig. 14 is an enlarged sectional view illustrating a range surrounded by an alternate long and two short dashes line XIV in Fig. 4;
Fig. 15 is a view illustrating a first process of a method for producing the proximity sensor of the first embodiment;
Fig. 16 is a view illustrating a second process of the method for producing the proximity sensor of the first embodiment;
Fig. 17 is a view illustrating a third process of the method for producing the proximity sensor of the first embodiment;
Fig. 18 is a view illustrating a fourth process of the method for producing the proximity sensor of the first embodiment;
Fig. 19 is a view illustrating a fifth process of the method for producing the proximity sensor of the first embodiment;
Fig. 20 is a view illustrating a sixth process of the method for producing the proximity sensor of the first embodiment;
Fig. 21 is a perspective view illustrating a proximity sensor according to a modification of the first embodiment;
Fig. 22 is an exploded perspective view illustrating the proximity sensor of the modification of the first embodiment;
Fig. 23 is a sectional view taken on a line XXIII-XXIII in Fig. 21;
Fig. 24 is a view illustrating a first process of a method for producing the proximity sensor of the modification of the first embodiment;
Fig. 25 is a view illustrating a second process of the method for producing the proximity sensor of the modification of the first embodiment;
Fig. 26 is a view illustrating a third process of the method for producing the proximity sensor of the modification of the first embodiment;
Fig. 27 is a table illustrating an experimental condition and a result of Experimental example 1 performed with respect to the first embodiment;
Fig. 28 is a table illustrating an experimental condition and a result of Experimental example 2 performed with respect to the first embodiment;
Fig. 29 is a perspective view illustrating a proximity sensor according to a second embodiment;
Fig. 30 is an exploded perspective view illustrating the proximity sensor of the second embodiment;
Fig. 31 is a sectional view taken on a line XXXI-XXXI in Fig. 29;
Fig. 32 is a sectional view taken on a line XXXII-XXXII in Fig. 29;
Fig. 33 is an enlarged sectional view illustrating a neighborhood of a detection coil unit included in the proximity sensor of the second embodiment;
Fig. 34 is a perspective view schematically illustrating an internal structure of the detection coil unit included in the proximity sensor of the second embodiment;
Fig. 35 is a perspective view illustrating a flow control member included in the proximity sensor of the second embodiment;
Fig. 36 is a sectional perspective view corresponding to the flow control member in Fig. 35;
Fig. 37 is another perspective view illustrating the flow control member included in the proximity sensor of the second embodiment;
Fig. 38 is a sectional perspective view corresponding to the flow control member in Fig. 37;
Fig. 39 is a sectional view taken on a line XXXIX-XXXIX in Fig. 31;
Fig. 40 is a sectional view taken on a line XL-XL in Fig. 31;
Fig. 41 is a sectional view taken on a line XLI-XLI in Fig. 31;
Fig. 42 is a perspective view illustrating a front cover included in the proximity sensor of the second embodiment;
Fig. 43 is a view illustrating the front cover when the front cover is viewed in a direction indicated by an arrow XLIII in Fig. 42;
Fig. 44 is a view illustrating the front cover when the front cover is viewed in a direction indicated by an arrow XLIV in Fig. 42;
Fig. 45 is a view illustrating the front cover when the front cover is viewed in a direction indicated by an arrow XLV in Fig. 42;
Fig. 46 is a view illustrating the front cover when the front cover is viewed in a direction indicated by an arrow XLVI in Fig. 42;
Fig. 47 is a perspective view illustrating a front end portion of the proximity sensor of the second embodiment;
Fig. 48 is an enlarged sectional view illustrating a range surrounded by an alternate long and two short dashes line XLVIII in Fig. 31;
Fig. 49 is an enlarged sectional view illustrating a range surrounded by an alternate long and two short dashes line XLIX in Fig. 32;
Fig. 50 is a view illustrating a first process of a method for producing the proximity sensor of the second embodiment;
Fig. 51 is a view illustrating a second process of the method for producing the proximity sensor of the second embodiment;
Fig. 52 is a view illustrating a third process of the method for producing the proximity sensor of the second embodiment;
Fig. 53 is a view illustrating a fourth process of the method for producing the proximity sensor of the second embodiment;
Fig. 54 is a view illustrating a fifth process of the method for producing the proximity sensor of the second embodiment;
Fig. 55 is a view illustrating a sixth process of the method for producing the proximity sensor of the second embodiment;
Fig. 56 is a sectional view illustrating the proximity sensor that does not include the flow control member;
Fig. 57 is a sectional view illustrating the proximity sensor including another flow control member;
Fig. 58 is a sectional view illustrating the proximity sensor of the second embodiment;
Fig. 59 is a perspective view illustrating a proximity sensor according to a modification of the second embodiment;
Fig. 60 is an exploded perspective view illustrating the proximity sensor of the modification of the second embodiment;
Fig. 61 is a sectional view taken on a line LXI-LXI in Fig. 59;
Fig. 62 is a view illustrating a first process of a method for producing the proximity sensor of the modification of the second embodiment;
Fig. 63 is a view illustrating a second process of the method for producing the proximity sensor of the modification of the second embodiment; and
Fig. 64 is a view illustrating a third process of the method for producing the proximity sensor of the modification of the second embodiment.

### DETAILED DESCRIPTION

Hereinafter, embodiments and Examples of the present invention will be described with reference to the drawings. In the embodiments and Examples, the present invention is not limited to the number of pieces and the amount unless otherwise noted. In the embodiments and Examples, the identical or equivalent component is designated by the identical numeral, and overlapping description may be omitted.

### [First embodiment]

### (Entire configuration)

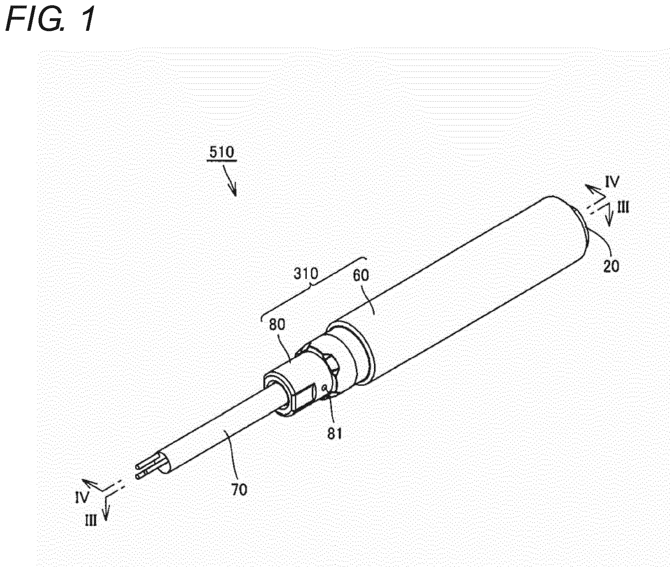

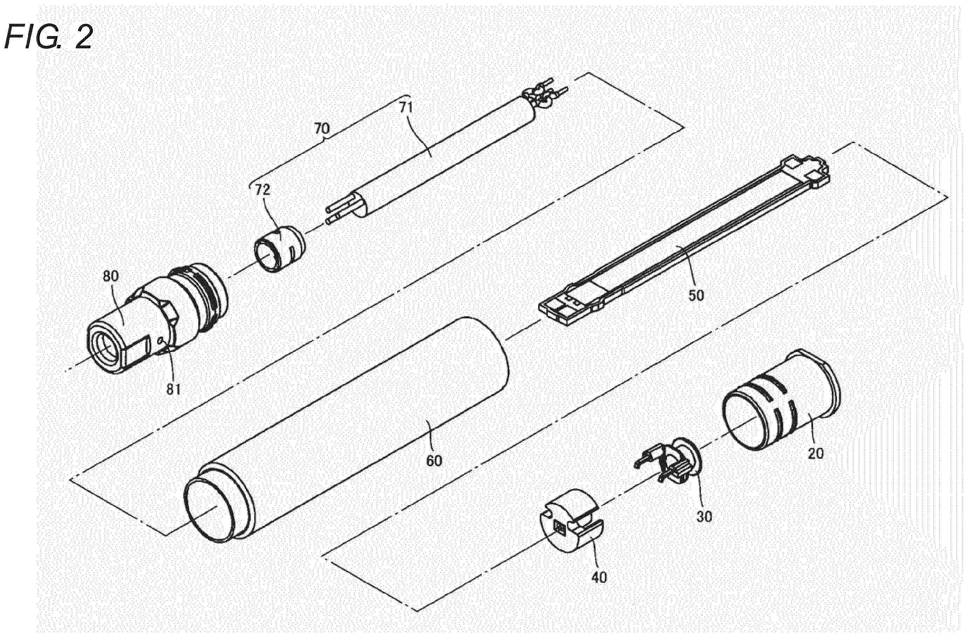

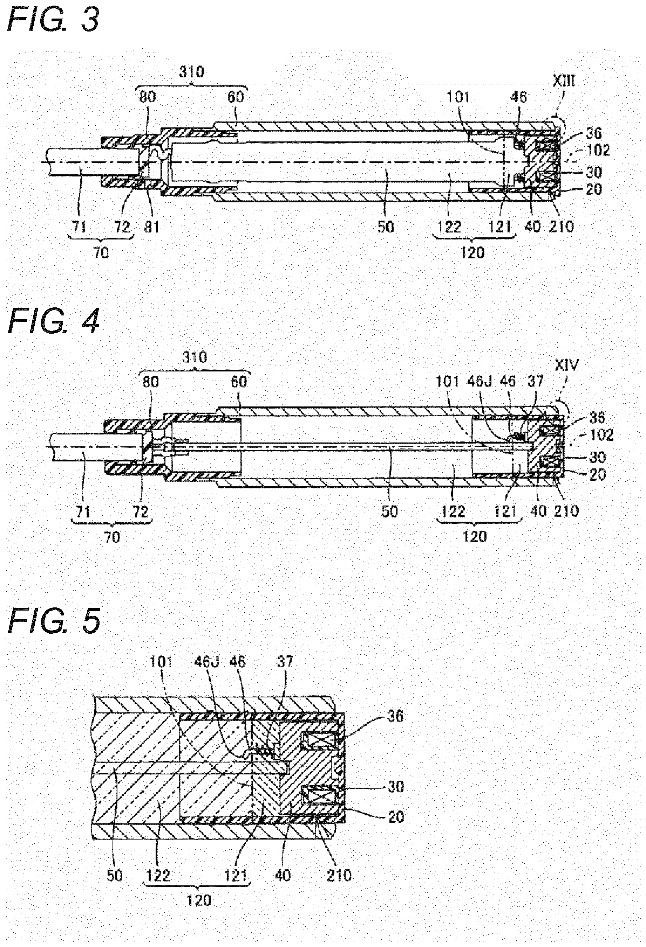

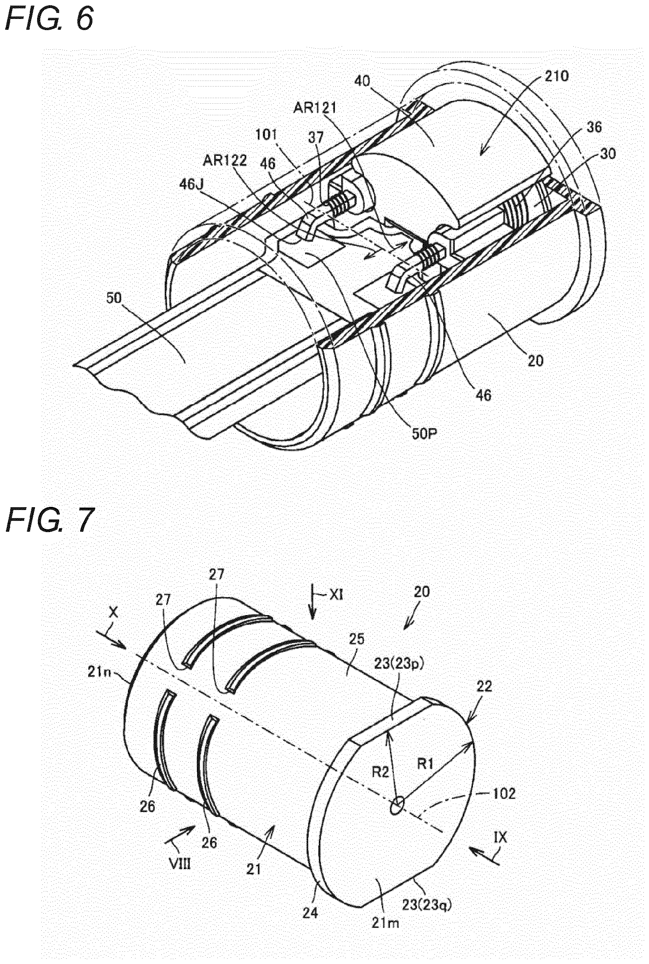

A proximity sensor 510 according to a first embodiment will be described with reference to Figs. 1 to 14. Fig. 1 is a perspective view illustrating the proximity sensor 510. Fig. 2 is an exploded perspective view illustrating the proximity sensor 510. Fig. 3 is a sectional view taken on a line III-III in Fig. 1. Fig. 4 is a sectional view taken on a line IV-IV in Fig. 1. Fig. 5 is an enlarged sectional view illustrating a neighborhood of a detection coil unit 210 included in the proximity sensor 510. Fig. 6 is a perspective view schematically illustrating an internal structure of the detection coil unit 210 included in the proximity sensor 510.

Referring to Figs. 1 to 6, the proximity sensor 510 is an induction-type proximity sensor that detects the approach or presence of a detection target by generating a magnetic field in a detection region. A conductive object is the detection target detected by the proximity sensor 510. Typically magnetic metals such as iron are the detection target detected by the proximity sensor 510, and nonmagnetic metals such as copper and aluminum may be the detection target.

The proximity sensor 510 has a columnar appearance that extends along a virtual center axis 102 (see Figs. 3 and 4). The proximity sensor 510 includes a detection coil unit 210 (see Figs. 3 to 6), a front cover 20 (a coil case), a printed board 50 (see Figs. 2 to 6), a base metallic part 60, a clamp 80, and a ring cord 70.

The detection coil unit 210 is provided as the detection unit that detects the approach or presence of the detection target. The detection coil unit 210 generates the magnetic field. The detection coil unit 210 is provided on a front end side of the proximity sensor 510 opposed to the detection region. The detection coil unit 210 is constructed by a combination of a core body 40, an electromagnetic coil 36 (see Figs. 3 to 6), a coil spool 30 (see Figs. 2 to 6), and a coil pin 46 (see Figs. 3 to 6).

The core body 40 is made of a material such as ferrite which has a high frequency property. The core body 40 has a function of enhancing a coil property of the detection coil unit 210 and of concentrating a magnetic flux on the detection region. The electromagnetic coil 36 is a coil wire, and is wound around the coil spool 30. The electromagnetic coil 36 is wound about a center axis 102. The center axis 102 also acts as a winding center axis for the electromagnetic coil 36.

The coil spool 30 (a spool body) is made of a resin having an electrical insulating property. The coil spool 30 is accommodated in a ring-like groove formed in the core body 40. The coil pin 46 is made of conductive metal. The coil pin 46 is supported by the coil spool 30. The coil pin 46 has a shape that extends from the detection coil unit 210 toward the side of the printed board 50. Using solder (not illustrated), an extending end of the coil pin 46 is connected to a pattern 50P (see Fig. 6) formed on the printed board 50.

A leading end 37 of the electromagnetic coil 36 drawn from the outer circumference of the coil spool 30 is wound around a root portion of the coil pin 46 extending from the detection coil unit 210. The electromagnetic coil 36 and the printed board 50 are electrically connected to each other through the coil pin 46 and the solder (not illustrated).

The detection coil unit 210 is accommodated in the front cover 20 (the coil case). The front cover 20 is made of resin. The front cover 20 is made of a thermoplastic resin. For example, the front cover 20 is made of a material such as PBT (polybutylene terephthalate) which exerts a good adhesion property with respect to the thermoplastic resin forming a thermoplastic resin portion 122. The front cover 20 is provided as a front end cover in which the detection coil unit 210 is accommodated. The front cover 20 closes a front end of the base metallic part 60 having a cylindrical shape. The front cover 20 is provided mainly in order to shut off and protect the detection coil unit 210 from an external atmosphere.

The front cover 20 has the cylindrical shape with a bottom. The front cover 20 extends cylindrically with the center axis 102 as the center, and one end of the front cover 20 is closed while the other end is opened. An end surface on the closed end side of the front cover 20 constitutes a detection surface of the proximity sensor 510.

The printed board 50 has an elongated planar shape. The printed board 50 extends with the center axis 102 as a longitudinal direction. Various electronic components (not illustrated) such as a transistor, a diode, a resistor, and a capacitor are mounted on the printed board 50. The electronic components also include one that is electrically connected to the detection coil unit 210. A light emitting diode (LED) (not illustrated) is mounted on the printed board 50. The light emitting diodes are provided in the surface and a back side of the printed board 50 to act as a light emitting unit that indicates a detection state.

The base metallic part 60 is provided as a body case in which the electronic components such as the transistor, the diode, the resistor, and the capacitor are accommodated. The base metallic part 60 constitutes an outline of the proximity sensor 510 on the outer circumference of the center axis 102. The base metallic part 60 has the cylindrical shape that extends with the center axis 102 as the center. The base metallic part 60 extending along the center axis 102 is opened at both ends. The front cover 20 is inserted in one of the opened ends of the base metallic part 60, whereby the front cover 20 is fixed to the base metallic part 60. For example, the base metallic part 60 has an inner diameter of 5 mm. Preferably the base metallic part 60 has an inner diameter of at least 5 mm.

The base metallic part 60 is made of metal. A thread to be used to fix the proximity sensor 510 to an external facility is formed on the outer circumferential surface of the base metallic part 60. The proximity sensor 510 of the first embodiment is what is called a sealed type proximity sensor in which the base metallic part 60 is disposed on the outer circumference of the detection coil unit 210. The proximity sensor 510 may be applied to what is called a non-sealed type proximity sensor in which the base metallic part 60 is disposed at a position deviated in the axial direction of the center axis 102 from the outer circumference of the detection coil unit 210.

The clamp 80 is provided as a connection member that is connected to the base metallic part 60 from the rear end side of the proximity sensor 510. The clamp 80 is connected to the rear end of the base metallic part 60 having the cylindrical shape. The clamp 80 is inserted in the rear end of the base metallic part 60. The clamp 80 extends cylindrically with the center axis 102 as the center while being integral with the base metallic part 60. The base metallic part 60 and the clamp 80 constitute a cylindrical case 310 that extends cylindrically with the center axis 102 as the center. The printed board 50 and the electronic components mounted on the printed board 50 are accommodated in the cylindrical case 310.

The light emitting diode mounted on the printed board 50 is positioned in the clamp 80. The clamp 80 is made of resin. The clamp 80 is made of a transparent or translucent resin such that the emission of the light emitting diode can visually be recognized from the outside of the proximity sensor 510. For example, the clamp 80 is made of polyamide. Agate 81 is formed in the clamp 80. The gate 81 is provided as a through-hole through which the resin is injected into the cylindrical case 310 in producing the proximity sensor 510.

The ring cord 70 is electrically connected to the printed board 50 in the cylindrical case 310. The ring cord 70 is drawn from the rear end side of the cylindrical case 310. The ring cord 70 is provided as a rear cover that closes the rear end of the cylindrical case 310.

The ring cord 70 includes a cable 71 and a ring member 72. The ring member 72 is provided so as to cover the end portion of the cable 71 in the cylindrical case 310. The ring member 72 ensures a joining property between the cable 71 and a sealing resin 120 provided in the cylindrical case 310. For example, the ring member 72 is made of PBT (polybutylene terephthalate). For example, the cable 71 is coated with polyvinyl chloride.

In the cylindrical case 310, the sealing resin 120 is formed by the injection of the resin. In the proximity sensor 510, a case member in which the detection coil unit 210 and the printed board 50 are accommodated is constructed by the cylindrical case 310, the ring cord 70, and the front cover 20. The sealing resin 120 is provided such that a space of the case member surrounded by the cylindrical case 310 and the front cover 20 and the ring cord 70, which close the front and rear ends of the cylindrical case 310, is filled with the sealing resin 120. The sealing resin 120 seals the detection coil unit 210 accommodated in the front cover 20 and the printed board 50 and electronic components, which are accommodated in a cylindrical case 310.

### (Sealing resin 120)

The sealing resin 120 includes a thermosetting resin portion 121 and a thermoplastic resin portion 122. The thermosetting resin portion 121 is made of a thermosetting resin, and seals the detection coil unit 210 (the core body 40, the electromagnetic coil 36, and the coil spool 30). The thermoplastic resin portion 122 is made of a thermoplastic resin, and formed in the portion other than the thermosetting resin portion 121 in the case member (the cylindrical case 310, the ring cord 70, and the front cover 20) to seal the printed board 50 and the electronic components. Although described in detail later, the thermoplastic resin having a hardness (Shore D) of 60 or less is selected to form the thermoplastic resin portion 122.

The thermosetting resin portion 121 and the thermoplastic resin portion 122 are provided so as to have a boundary in the front cover 20 indicated by an alternate long and two short dashes line 101 in Figs. 3 to 6. Referring to Fig. 6, the thermosetting resin portion 121 is formed on the side of the direction indicated by an arrow AR121 when viewed from the alternate long and two short dashes line 101, and the thermoplastic resin portion 122 is formed on the side of the direction indicated by an arrow AR122 when viewed from the alternate long and two short dashes line 101.

The thermosetting resin portion 121 seals part of the coil pin 46 (portion on the root side of the coil pin 46) while sealing at least the core body 40, the electromagnetic coil 36, and the coil spool 30. In the coil pin 46, the portion that is not sealed by the thermosetting resin portion 121 is sealed by the thermoplastic resin portion 122. In the coil pin 46, the portion (on the side of a leading end 46J) extending from the front of the portion around which the leading end 37 of the electromagnetic coil 36 (the coil wire) is wound is sealed by the thermoplastic resin portion 122 (see Fig. 5). In the coil pin 46, the portion soldered to the pattern 50P of the printed board 50 is sealed by the thermoplastic resin portion 122. Alternatively, in the coil pin 46, the portion (on the side of the leading end 46J) extending from the front of the portion around which the leading end 37 of the electromagnetic coil 36 (the coil wire) is wound may be sealed by the thermosetting resin portion 121. In this case, in the coil pin 46, the portion soldered to the pattern 50P of the printed board 50 is sealed by the thermosetting resin portion 121.

The thermoplastic resin that can be molded at low temperature and at low pressure is suitably used to form the thermoplastic resin portion 122. At least one selected from a group consisting of polyolefin, polyester, and polyamide can be cited as an example of the thermoplastic resin. Various additives such as a flame retardant, an organic/inorganic filler, a plasticizer, a colorant, and an antioxidant may be contained in the thermoplastic resin used to form the thermoplastic resin portion 122. The use of the thermoplastic resin having a hardness (Shore D) of 60 or less can reduce stress applied to the internal device due to heat and pressure during the filling of the resin, eliminate necessity for reaction curing, and shorten a process tact time.

A molding machine in which a resin filling pressure is arbitrarily adjusted in a range of 0.1 MPa to 10 MPa may be used as one that fills the thermoplastic resin portion 122 with the thermoplastic resin. The resin filling pressure may be set in the range of 0.1 MPa or more, more preferably the range of 1 MPa or more from the viewpoint of a property of filling the detailed structure of the proximity sensor 510 with the resin. The resin filling pressure may be set in the range of 10 MPa or less, more preferably the range of 6 MPa or less from the viewpoint of suppressing damage to the internal component.

An epoxy resin can be cited as a typical example of the thermosetting resin used to form the thermosetting resin portion 121. Preferably the thermosetting resin portion 121 has a small fluctuation in resin stress (stress relaxation) applied to the detection coil unit 210. Preferably the thermosetting resin portion 121 has an elastic modulus of 800 MPa or more at room temperature. Various additives such as a flame retardant, an organic/inorganic filler, a plasticizer, a colorant, and an antioxidant may be contained in the thermosetting resin used to form the thermosetting resin portion 121. The sealing resin 120 is not limited to the two-stage segmentation structure including the thermosetting resin portion 121 and the thermoplastic resin portion 122, but the sealing resin 120 may have a segmentation structure of at least three stages.

The viscosity of the thermoplastic resin portion 122 ranges preferably from 500 mPa•s to 10000 mPa•s when being measured with a rheometer AR2000EX (a product of TA Instruments Japan Inc.) at a shearing speed of 10 (1/s) and at a temperature of 190°C. The viscosity of the thermoplastic resin portion 122 ranges more preferably from 500 mPa•s to 8000 mPa•s when being measured with the rheometer AR2000EX (the product of TA Instruments Japan Inc.) at a shearing speed of 10 (1/s) and at a temperature of 190°C.

### (Front cover 20 and base metallic part 60)

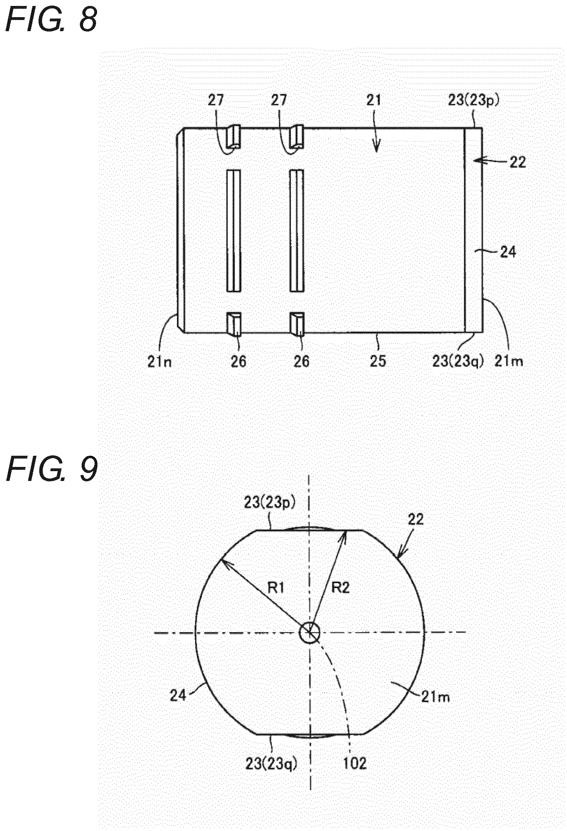

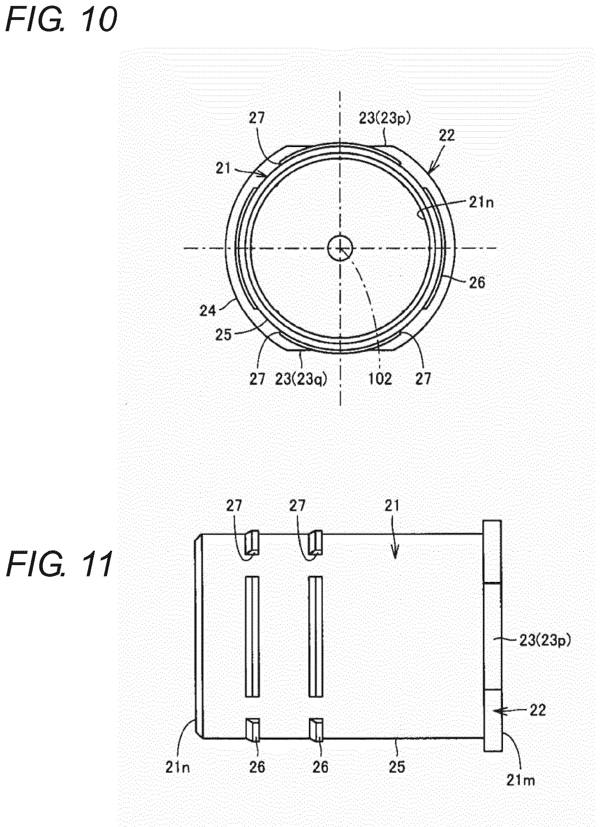

Fig. 7 is a perspective view illustrating the front cover 20. Fig. 8 is a view illustrating the front cover 20 when the front cover 20 is viewed in a direction indicated by an arrow VIII in Fig. 7. Fig. 9 is a view illustrating the front cover 20 when the front cover 20 is viewed in a direction indicated by an arrow IX in Fig. 7. Fig. 10 is a view illustrating the front cover 20 when the front cover 20 is viewed in a direction indicated by an arrow X in Fig. 7. Fig. 11 is a view illustrating the front cover 20 when the front cover 20 is viewed in a direction indicated by an arrow XI in Fig. 7. In the drawings, the center axis 102 is indicated when the front cover 20 is assembled in the proximity sensor 510.

Referring to Figs. 5 to 9, the front cover 20 includes a cylindrical portion 21, a rib-shape portion 26, and a guard portion 22 as structural components. The cylindrical portion 21 includes a closed end 21m in one of the end portions of the cylindrical portion 21 and an opened end 21n in the other end portion of the cylindrical portion 21. A space in which the detection coil unit 210 is accommodated is formed in the cylindrical portion 21. The cylindrical portion 21 includes an outer circumferential surface 25.

The rib-shape portion 26 is projected from the outer circumferential surface 25 of the cylindrical portion 21. An air vent 27 is formed in the rib-shape portion 26. The guard portion 22 is provided on the side of the closed end 21m of the cylindrical portion 21. The guard portion 22 has a circular shape with the center axis 102 as the center, and a diameter of the guard portion 22 is larger than that of the outer circumferential surface 25 of the cylindrical portion 21. The guard portion 22 includes an outer circumferential edge 24.

A notch 23 is formed in the guard portion 22. The notch 23 is formed such that a length from the center axis 102 to the outer circumferential edge 24 of the guard portion 22 is not uniform around the center axis 102. As illustrated in Figs. 7 and 9, the guard portion 22 has a length R1 from the center axis 102 to the outer circumferential edge 24 of the guard portion 22 at the position where the notch 23 is not formed, and has a length R2 from the center axis 102 to the outer circumferential edge 24 of the guard portion 22 at the position where the notch 23 is formed. The length R2 is a variable value smaller than the length R1 (R2 < R1).

The notch 23 is provided such that the outer circumferential edge 24 of the guard portion 22 is liner when in the direction of the center axis 102. The notch 23 is provided such that the outer circumferential edge 24 of the guard portion 22 is a tangent to the outer circumferential surface 25 of the cylindrical portion 21 when viewed in the direction of the center axis 102. The notch 23 includes a notch 23p and a notch 23q. The notch 23p and the notch 23q are provided 180 degrees apart in the circle having the center axis 102 as the center.

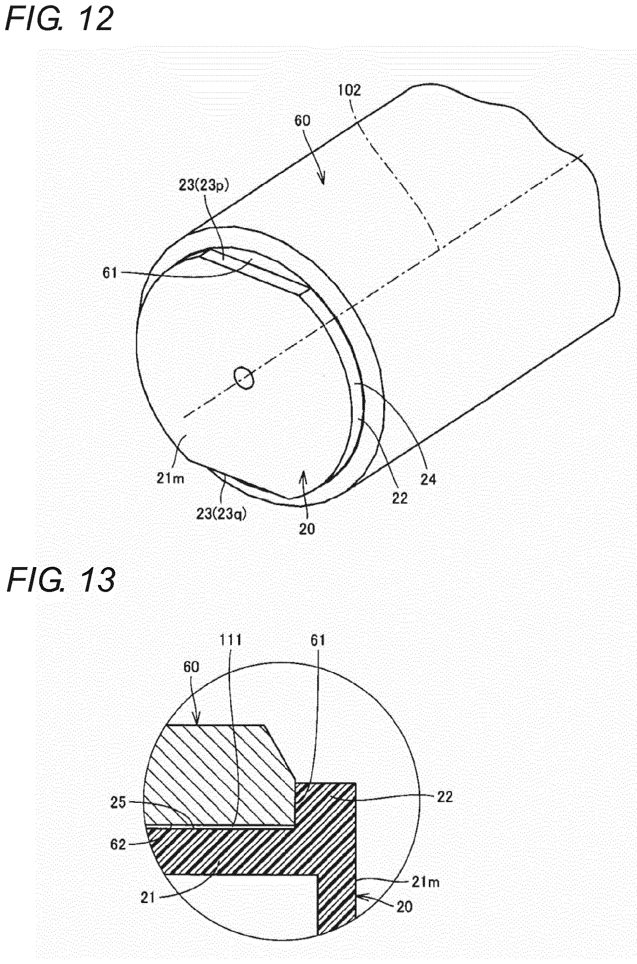

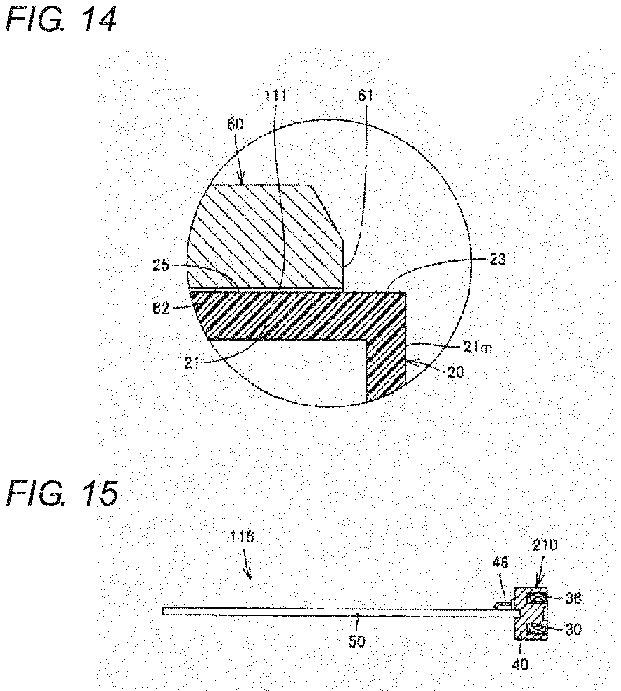

Fig. 12 is a perspective view illustrating a front end portion of the proximity sensor 510 (see Fig. 1). Fig. 13 is an enlarged sectional view illustrating a range surrounded by an alternate long and two short dashes line XIII in Fig. 3. Fig. 14 is an enlarged sectional view illustrating a range surrounded by an alternate long and two short dashes line XIV in Fig. 4.

Referring to Figs. 7 to 14, the base metallic part 60 is fitted on the outer circumference of the cylindrical portion 21 from the side of the end 21n (see Fig. 7), and the base metallic part 60 is assembled in the front cover 20 while abutting on the guard portion 22. The base metallic part 60 includes a front surface 61 disposed on the front end side of the proximity sensor 510. The guard portion 22 of the front cover 20 and the front surface 61 of the base metallic part 60 are in contact with each other. The base metallic part 60 abuts on the guard portion 22 to regulate the movement of the front cover 20 onto the rear end side of the proximity sensor 510.

In the base metallic part 60, the rib-shape portion 26 is compressively deformed by the base metallic part 60. The front cover 20 is fixed to the base metallic part 60 by press-fitting. A gap 111 is formed between the outer circumferential surface 25 of the front cover 20 and the base metallic part 60. The gap 111 is set to a minute size enough for the resin, with which the cylindrical case 310 is filled, not to invade into the gap 111 during the production of the proximity sensor 510. For example, the gap 111 has a size of 0.3 mm or less.

Fig. 14 illustrates the section at the position where the notch 23 is provided in the guard portion 22. The notch 23 is provided to expose the gap 111 between the outer circumferential surface 25 of the front cover 20 and the base metallic part 60. The base metallic part 60 abuts on the guard portion 22, whereby the gap 111 is closed by the guard portion 22 while the gap 111 is communicated with the external space at the position where the notch 23 is provided.

### (Producing method)

A method for producing the proximity sensor 510 (see Fig. 1) will be described with reference to Figs. 15 to 20. Referring to Fig. 15, a sub-assembly 116 including the detection coil unit 210 and the printed board 50 is assembled. Specifically, the printed board 50 is connected to the core body 40 while the core body 40 and the coil spool 30, around which the electromagnetic coil 36 is wound, is combined. The leading end of the coil pin 46 is soldered to the surface (the pattern 50P in Fig. 6) of the printed board 50 to electrically connect the electromagnetic coil 36 and the printed board 50.

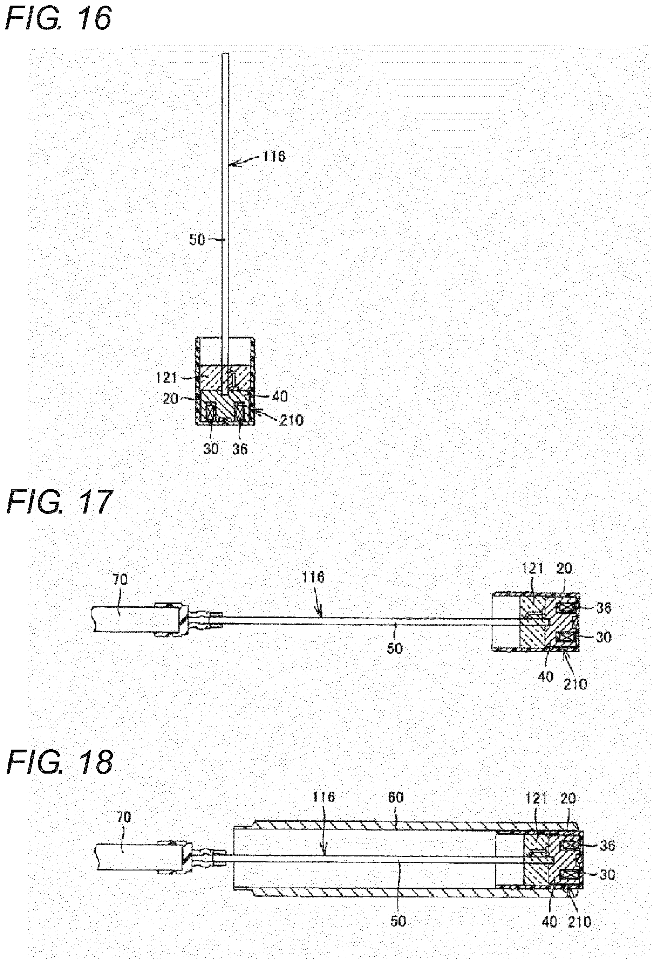

Referring to Fig. 16, the front cover 20 is assembled in the sub-assembly 116. Specifically, the front cover 20 is filled with the thermosetting resin as a primary injection resin. The sub-assembly 116 is inserted and disposed in the front cover 20 from the side of the detection coil unit 210 that detects the approach or presence of the detection target, thereby dipping the detection coil unit 210 in the thermosetting resin in the front cover 20. The thermosetting resin in the front cover 20 is cured by heating.

Referring to Fig. 17, the ring cord 70 is assembled in the sub-assembly 116. Specifically, the leading end of the cable of the ring cord 70 is soldered onto the surface of the printed board 50. Referring to Fig. 18, the base metallic part 60 is assembled in the front cover 20. Specifically, the ring cord 70 and the printed board 50 are sequentially inserted from the front end side of the base metallic part 60, and the front cover 20 is press-fitted in the front end side of the base metallic part 60.

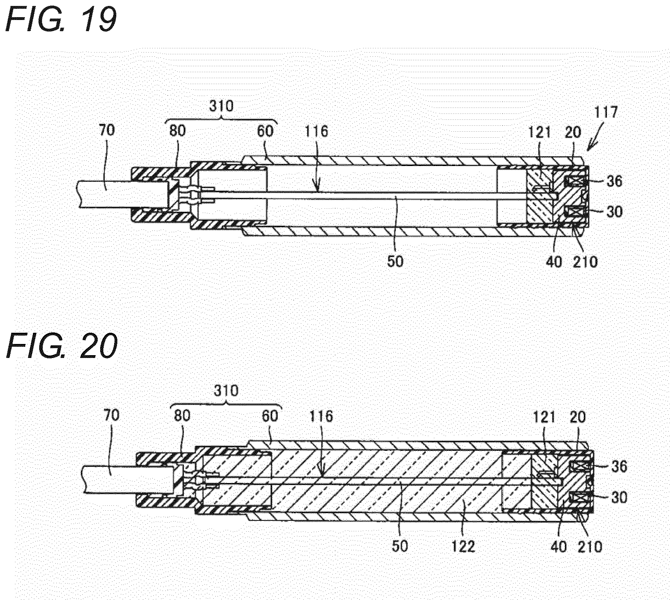

Referring to Fig. 19, the clamp 80 is assembled in the base metallic part 60. Specifically, the ring cord 70 is inserted from the front end side of the clamp 80, and the clamp 80 is press-fitted in the rear end side of the base metallic part 60. Then the base metallic part 60 and the clamp 80 are fixed to each other using fixing methods such as gouging, swaging, adhesion, and welding. Therefore, an assembly 117 is obtained. The process of fixing the base metallic part 60 and the clamp 80 to each other may be performed after a process of filling the proximity sensor with a secondary filling resin subsequent thereto.

Referring to Fig. 20, the cylindrical case 310 including the base metallic part 60 and the clamp 80 is filled with the thermoplastic resin as the secondary filling resin. More specifically, the assembly 117 obtained through the process is set in a die using a positioning jig. The high-temperature resin is injected into the cylindrical case 310 through the gate 81 (see Figs. 1 and 3). The thermoplastic resin portion 122 is formed by cooling and solidifying the thermoplastic resin. The printed board 50 and various electronic components in the cylindrical case 310 are sealed by the resin. The proximity sensor 510 in Fig. 1 is completed through the above processes.

### (Operation and effect)

In the proximity sensor 510, the detection coil unit 210 is sealed by the thermosetting resin portion 121. For example, an epoxy resin is used as the thermosetting resin portion 121. The core body 40 of the detection coil unit 210 includes a burned material such as ferrite. Assuming that the detection coil unit 210 is sealed by the thermoplastic resin portion, the externally-applied stress easily changes with time in the core body 40 and the electromagnetic coil 36, which constitute the detection coil unit 210. The intensity (magnetic flux density) of a magnetic field formed by the core body 40 and the electromagnetic coil 36 becomes easily unstable when the externally-applied stress increases or decreases. Specifically, when the stress applied to the core body 40 changes, a magnetic property of the core body 40 changes due to an influence of a magnetoelastic coupling (magnetic striction). When the stress applied to the core body 40 changes, a magnetic domain constituting the core body 40 changes, thereby changing the magnetic flux. When the stress applied to the core body 40 changes, sometimes a coil diameter or a distance between the coil wires changes. In this case, an L value or a C value of the coil changes. The fluctuation of the property leads to fluctuation of detection sensitivity of the proximity sensor.

In the first embodiment, when the detection coil unit 210 is sealed by the thermosetting resin portion 121, the stress applied to the detection coil unit 210 is stabilized for a long term compared with the case that the detection coil unit 210 is sealed using the thermoplastic resin. For example, the stress applied to the detection coil unit 210 from the thermosetting resin portion 121 hardly changes immediately after the production of the proximity sensor 510, after the inspection of the proximity sensor 510, after the product shipment of the proximity sensor 510, and during the use of the proximity sensor 510. The proximity sensor 510 can detect the approach or presence of the detection target with stable sensitivity.

On the other hand, the printed board 50 is sealed by the thermoplastic resin portion 122. The resin having a hardness (Shore D) of 60 or less is used as the thermoplastic resin portion 122. The stress remaining in the electronic device after the sealing can be relaxed in the case that the sealing is performed using the low-hardness thermoplastic resin. Even if the printed board 50 is sealed using the thermoplastic resin portion 122, the stress applied to the printed board 50 after the sealing is smaller compared with the case that the printed board 50 is sealed using the thermosetting resin portion 121. According to the proximity sensor 510, the stress applied to the printed board 50 and the electronic components mounted on the printed board 50 can be relaxed.

The proximity sensor 510 is sealed using the thermosetting resin portion 121 and the thermoplastic resin portion 122. The proximity sensor 510 can be produced in a shorter production time compared with the case that the inside of the proximity sensor is wholly sealed using the thermosetting resin portion.

As described above, the viscosity of the thermoplastic resin portion 122 ranges preferably from 500 mPa•s to 10000 mPa•s when being measured with the rheometer AR2000EX (the product of TA Instruments Japan Inc.) at a shearing speed of 10 (1/s) and at a temperature of 190°C. The viscosity of the thermoplastic resin portion 122 ranges more preferably from 500 mPa•s to 8000 mPa•s when being measured with the rheometer AR2000EX (the product of TA Instruments Japan Inc.) at a shearing speed of 10 (1/s) and at a temperature of 190°C.

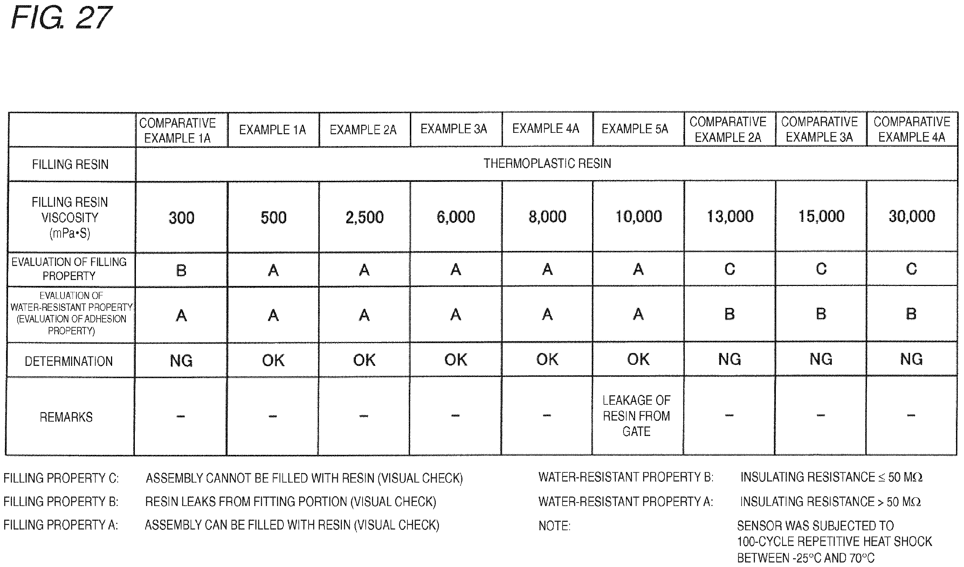

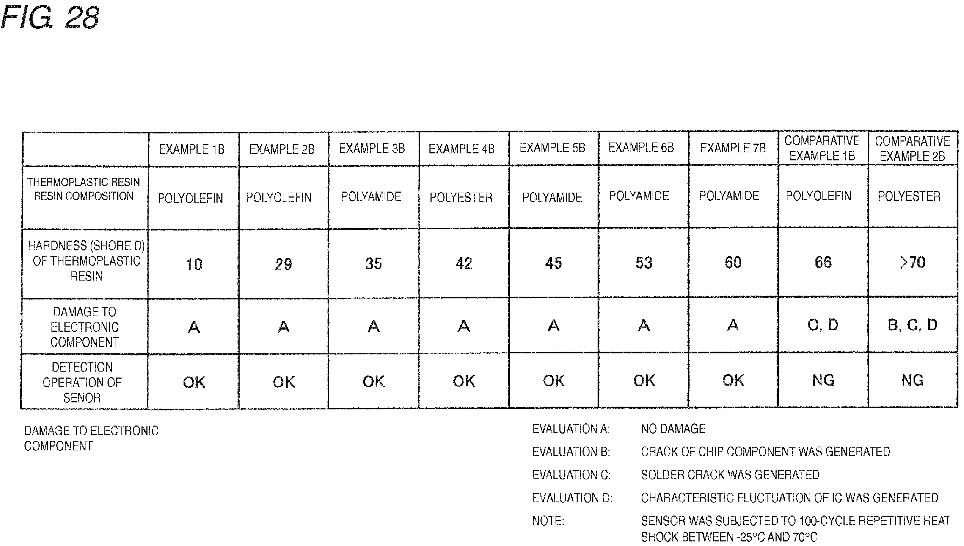

According to the configurations, the thermoplastic resin portion 122 can well adhere to the thermosetting resin portion 121 at an interface between the thermosetting resin portion 121 and the thermoplastic resin portion 122. This point is described as Example in detail later with reference to Figs. 27 and 28.

### (Modification)

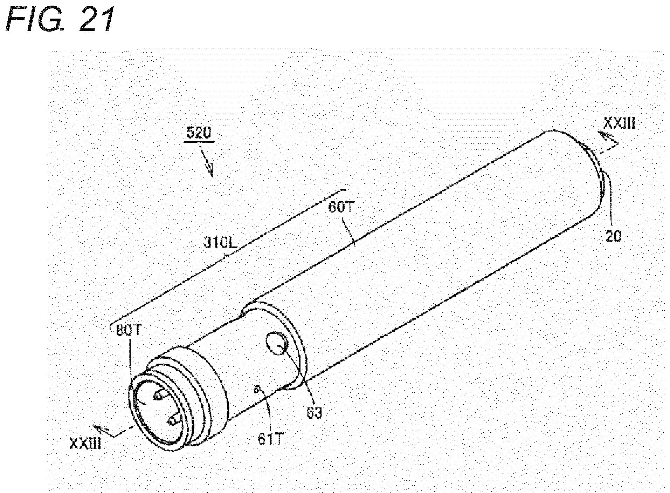

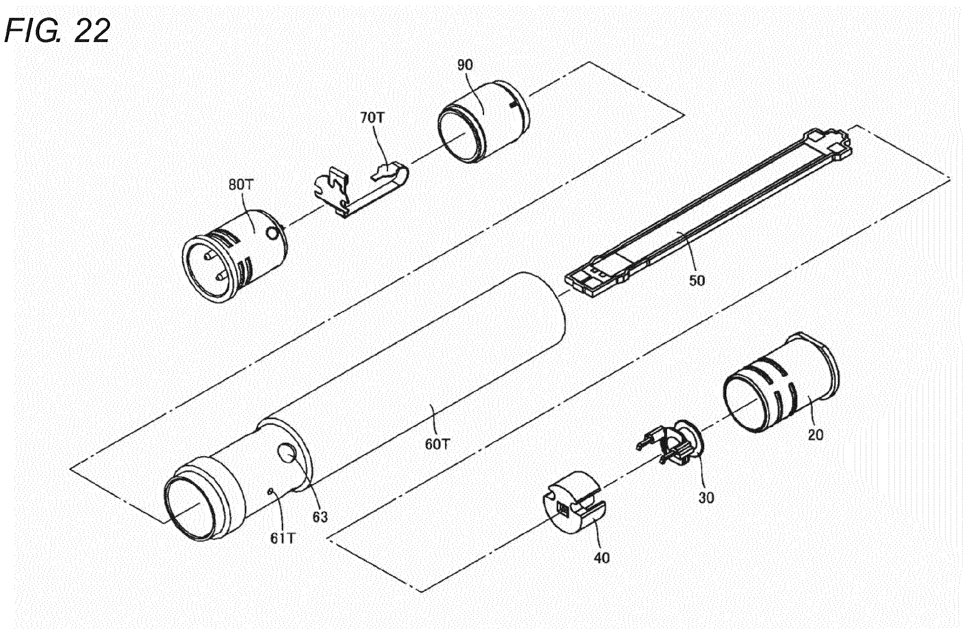

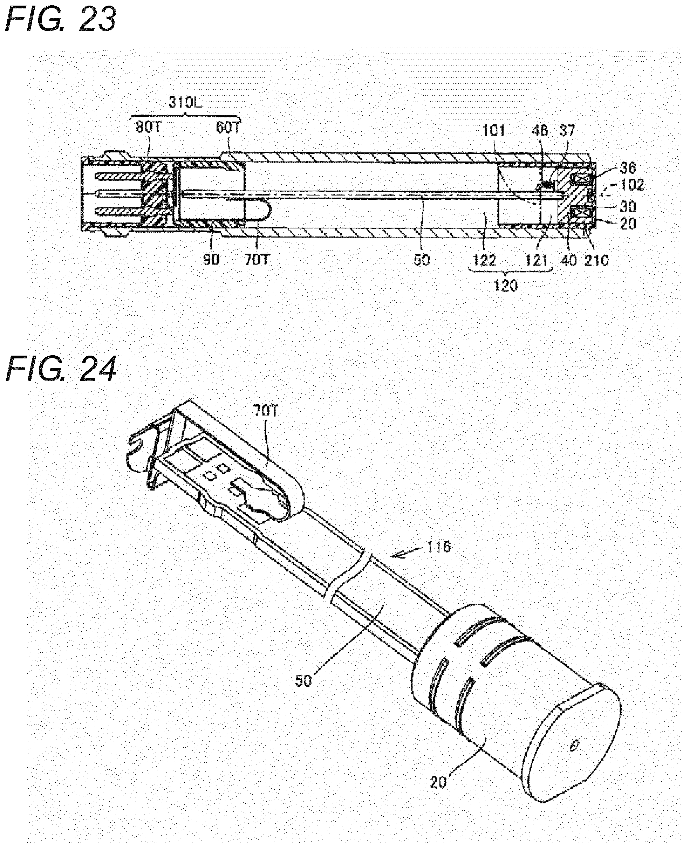

A proximity sensor 520 according to a modification of the proximity sensor 510 (see Fig. 1) will be described with reference to Figs. 21 to 26. In the modification, only a difference between the proximity sensor 510 and the proximity sensor 520 is described, and the overlapping description is neglected. Fig. 21 is a perspective view illustrating the proximity sensor 520. Fig. 22 is an exploded perspective view illustrating the proximity sensor 520. Fig. 23 is a sectional view taken on a line XXIII-XXIII in Fig. 21.

Referring to Figs. 21 to 23, the proximity sensor 520 includes the detection coil unit 210 (see Fig. 23), the front cover 20, the printed board 50 (see Figs. 22 and 23), a base metallic part 60T, a harness 70T, a receptacle 80T, and a light emitting unit cover 90. The proximity sensor 520 is substantially identical to the proximity sensor 510 in the configurations of the detection coil unit 210, the front cover 20, and the printed board 50.

The base metallic part 60T is provided as the body case in which the electronic components such as the transistor, the diode, the resistor, and the capacitor are accommodated. The base metallic part 60T constitutes the outline of the proximity sensor 520 on the outer circumference of the center axis 102. The base metallic part 60T has the cylindrical shape that extends with the center axis 102 as the center. The base metallic part 60T extending along the center axis 102 is opened at both the ends. The front cover 20 is inserted in one of the opened ends of the base metallic part 60T, whereby the front cover 20 is fixed to the base metallic part 60T.

The base metallic part 60T is made of metal. A thread to be used to fix the proximity sensor 520 to an external facility is formed on the outer circumferential surface of the base metallic part 60T. A visible window 63 is formed in the base metallic part 60T as the opening that is used to visibly recognize the emission of the light emitting diode (not illustrated) mounted on the printed board 50. Agate 61T is also formed in the base metallic part 60T. The gate 61T is provided as the through-hole through which the resin is injected into a cylindrical case 310L in producing the proximity sensor 520.

The proximity sensor 520 of the modification is what is called a sealed type proximity sensor in which the base metallic part 60T is disposed on the outer circumference of the detection coil unit 210. The proximity sensor 520 may be applied to what is called a non-sealed type proximity sensor in which the base metallic part 60T is disposed at a position deviated in the axial direction of the center axis 102 from the outer circumference of the detection coil unit 210.

The light emitting unit cover 90 has the cylindrical shape and is inserted (press-fitted) in the base metallic part 60T. The light emitting unit cover 90 is made of resin. The light emitting unit cover 90 is made of a transparent or translucent resin such that the emission of the light emitting diode is visibly recognized from the outside of the proximity sensor 520. The light emitting unit cover 90 is disposed so as to be oriented toward the light emitting diode on the printed board 50, and the light emitting unit cover 90 is provided so as to close the visible window 63. Because of the light emitting unit cover 90, the sealing resin 120 with which the base metallic part 60T is filled is not exposed to the external space through the visible window 63.

The light emitting unit cover 90 is provided so as to be able to be inserted from the opened end of the base metallic part 60T. The light emitting unit cover 90 is not integral with the base metallic part 60T because of outsert molding, but the light emitting unit cover 90 is provided so as to be able to separate from the base metallic part 60T. In the proximity sensor 520, the thermoplastic resin is used as the resin sealing the electronic components in the base metallic part 60T. The thermoplastic resin exerts the low fluidity in filling the base metallic part 60T with the resin. Because the resin hardly flows between the inner circumferential surface of the base metallic part 60T and the light emitting unit cover 90, it is not necessary to adopt the outsert molding that is of a technique of bringing the inner circumferential surface of the base metallic part 60T and the light emitting unit cover 90 into close contact with each other. A production cost of the proximity sensor 520 can be reduced by simplifying the configurations of the light emitting unit cover 90 and the base metallic part 60T.

The receptacle 80T is provided so as to close the opened end on the rear end side of the cylindrical base metallic part 60T. The receptacle 80T is provided as a connector cover including a pin that connects the proximity sensor 520 to the outside. The receptacle 80T extends cylindrically with the center axis 102 as the center while being integral with the base metallic part 60T. The base metallic part 60T and the receptacle 80T constitute the cylindrical case 310L that extends cylindrically with the center axis 102 as the center. The printed board 50 and the electronic components mounted on the printed board 50 are accommodated in the cylindrical case 310L.

The harness 70T is a flexible wiring member. The harness 70T is provided in the base metallic part 60T as the wiring member that electrically connects the printed board 50 and the pin of the receptacle 80T. The harness 70T is connected to the pin of the receptacle 80T and the printed board 50 by the soldering.

### (Sealing resin 120)

In the cylindrical case 310L, the sealing resin 120 is formed by the injection of the resin. In the proximity sensor 520, the case member in which the detection coil unit 210 and the printed board 50 are accommodated is constructed by the cylindrical case 310L, the receptacle 80T, and the front cover 20. The sealing resin 120 is provided such that the space of the case member surrounded by the cylindrical case 310L and the front cover 20 and receptacle 80T, which close the front and rear ends of the cylindrical case 310L, is filled with the sealing resin 120. The sealing resin 120 seals the detection coil unit 210 accommodated in the front cover 20 and the printed board 50 and electronic components which are accommodated in the cylindrical case 310N.

The sealing resin 120 includes the thermosetting resin portion 121 and the thermoplastic resin portion 122. The thermosetting resin portion 121 is made of a thermosetting resin, and seals the detection coil unit 210 (the core body 40, the electromagnetic coil 36, and the coil spool 30). The thermoplastic resin portion 122 is made of a thermoplastic resin, and formed in the portion other than the thermosetting resin portion 121 in the case member (the cylindrical case 310L, the receptacle 80T, and the front cover 20) to seal the printed board 50 and the electronic components. The thermoplastic resin portion 122 has a hardness (Shore D) of 60 or less.

The thermosetting resin portion 121 and the thermoplastic resin portion 122 are provided so as to have the boundary in the front cover 20 indicated by the alternate long and two short dashes line 101 in Fig. 23. The thermosetting resin portion 121 seals part of the coil pin 46 (portion on the root side of the coil pin 46) while sealing at least the core body 40, the electromagnetic coil 36, and the coil spool 30. In the coil pin 46, the portion that is not sealed by the thermosetting resin portion 121 is sealed by the thermoplastic resin portion 122. In the coil pin 46, the portion extending from the front of the portion around which the leading end 37 of the electromagnetic coil 36 (the coil wire) is wound is sealed by the thermoplastic resin portion 122.

In the coil pin 46, the portion soldered to the pattern of the printed board 50 is sealed by the thermoplastic resin portion 122. Alternatively, in the coil pin 46, the portion extending from the front of the portion around which the leading end 37 of the electromagnetic coil 36 (the coil wire) is wound may be sealed by the thermosetting resin portion 121. In this case, in the coil pin 46, the portion soldered to the pattern of the printed board 50 is sealed by the thermosetting resin portion 121.

The thermoplastic resin that can be molded at low temperature and at low pressure is suitably used to form the thermoplastic resin portion 122. At least one selected from a group consisting of polyolefin, polyester, and polyamide can be cited as an example of the thermoplastic resin. Various additives such as a flame retardant, an organic/inorganic filler, a plasticizer, a colorant, and an antioxidant may be contained in the thermoplastic resin used to form the thermoplastic resin portion 122. The use of the thermoplastic resin having a hardness (Shore D) of 60 or less can reduce the stress applied to the internal device due to the heat and the pressure during the filling of the resin, eliminate the necessity for the reaction curing, and shorten the process tact time.

An epoxy resin can be cited as a typical example of the thermosetting resin used to form the thermosetting resin portion 121. Preferably the thermosetting resin portion 121 has the small fluctuation in resin stress (the stress relaxation) applied to the detection coil unit 210. Preferably the thermosetting resin portion 121 has an elastic modulus of 800 MPa or more at room temperature. Various additives such as a flame retardant, an organic/inorganic filler, a plasticizer, a colorant, and an antioxidant may be contained in the thermosetting resin used to form the thermosetting resin portion 121. The sealing resin 120 is not limited to the two-stage segmentation structure including the thermosetting resin portion 121 and the thermoplastic resin portion 122, but the sealing resin 120 may have a segmentation structure of at least three stages.

The viscosity of the thermoplastic resin portion 122 ranges preferably from 500 mPa•s to 10000 mPa•s when being measured with the rheometer AR2000EX (the product of TA Instruments Japan Inc.) at a shearing speed of 10 (1/s) and at a temperature of 190°C. The viscosity of the thermoplastic resin portion 122 ranges more preferably from 500 mPa•s to 8000 mPa•s when being measured with the rheometer AR2000EX (the product of TA Instruments Japan Inc.) at a shearing speed of 10 (1/s) and at a temperature of 190°C.

### (Producing method)

A method for producing the proximity sensor 520 (see Fig. 21) will be described with reference to Figs. 24 to 26. Referring to Fig. 24, the sub-assembly 116 including the detection coil unit 210 and the printed board 50 is assembled (similarly to the case described with reference to Fig. 15). The front cover 20 is assembled in the sub-assembly 116 (similarly to the case described with reference to Fig. 16).

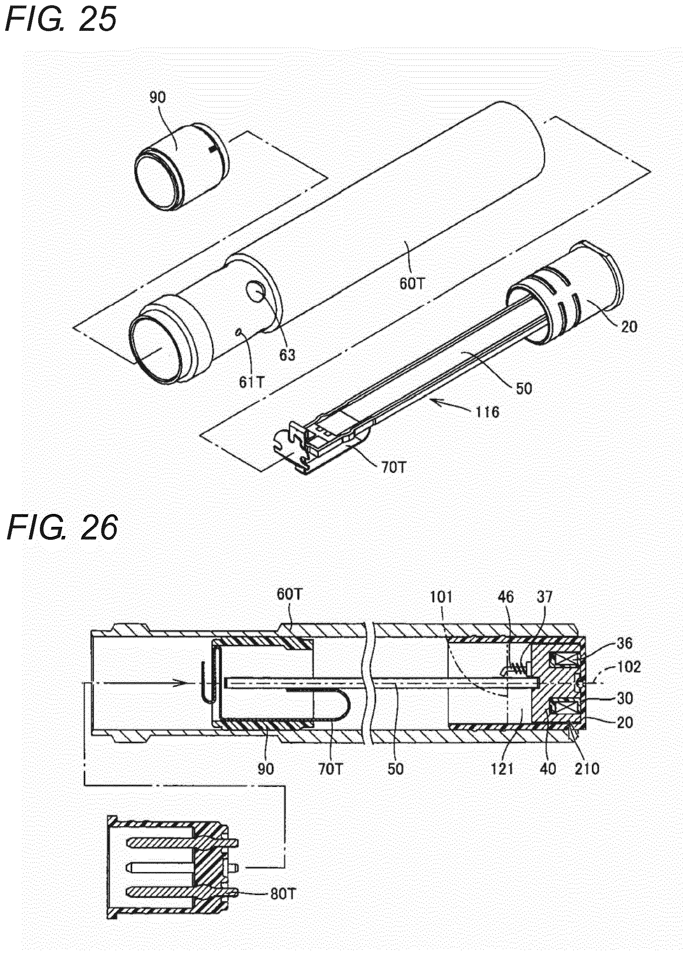

Then the harness 70T is assembled in the sub-assembly 116. Specifically, the harness 70T is soldered onto the surface of the printed board 50. Referring to Fig. 25, the base metallic part 60T is assembled in the front cover 20. Specifically, the harness 70T and the printed board 50 are sequentially inserted from the front end side of the base metallic part 60T, and the front cover 20 is press-fitted in the front end side of the base metallic part 60T. Then the light emitting unit cover 90 is press-fitted in the base metallic part 60T from the opening on the rear end side of the base metallic part 60T.

Referring to Fig. 26, the receptacle 80T is assembled in the base metallic part 60T. Specifically, the receptacle 80T is press-fitted in the rear end side of the base metallic part 60T. Then the base metallic part 60T and the receptacle 80T are fixed to each other using fixing methods such as the gouging, the swaging, the adhesion, and the welding. The process of fixing the base metallic part 60T and the receptacle 80T to each other may be performed after the process of filling the proximity sensor with the secondary filling resin subsequent thereto.

Then the cylindrical case 310L (see Fig. 23) including the base metallic part 60T and the receptacle 80T is filled with the thermoplastic resin as the secondary filling resin. More specifically, the assembly obtained through the process is set in the die using the positioning jig. The high-temperature resin is injected into the cylindrical case 310L through the gate 61T (see Fig. 25). The thermoplastic resin portion 122 (see Fig. 23) is formed by cooling and solidifying the thermoplastic resin. The printed board 50 and various electronic components in the cylindrical case 310L are sealed by the resin. The proximity sensor 520 in Fig. 21 is completed through the above processes.

### (Operation and effect)

In the proximity sensor 520, the detection coil unit 210 is sealed by the thermosetting resin portion 121. The stress applied to the detection coil unit 210 is stabilized for a long term compared with the case that the detection coil unit 210 is sealed using the thermoplastic resin portion. The proximity sensor 520 can detect the approach or presence of the detection target with stable sensitivity.

On the other hand, the printed board 50 is sealed by the thermoplastic resin portion 122. The resin having a hardness (Shore D) of 60 or less is used as the thermoplastic resin portion 122. According to the proximity sensor 520, the stress applied to the printed board 50 and the electronic components mounted on the printed board 50 can be relaxed. The proximity sensor 520 can be produced in a shorter production time compared with the case that the inside of the proximity sensor is wholly sealed using the thermosetting resin portion.

### [Experimental example 1]

Experimental example 1 performed with respect to the first embodiment will be described with reference to Fig. 27. The Experimental example 1 includes Comparative examples 1A, 2A, 3A, and 4A and Examples 1A, 2A, 3A, 4A, and 5A. In Experimental example 1, the assembly 117 in Fig. 19 was prepared. In the assembly 117 used in Experimental example 1, the base metallic part 60 had an inner diameter of 5 mm, the printed board 50 and the like were accommodated and disposed at predetermined positions, and the proximity sensor 510 had a total length of 80 mm. The thermoplastic resin portion 122 is not formed in the assembly 117.

The thermoplastic resins forming the thermoplastic resin portion 122 having different viscosities were prepared in Comparative examples 1A, 2A, 3A, and 4A and Examples 1A, 2A, 3A, 4A, and 5A. In Fig. 27, the viscosity value (mPa•s) of the filling resin was measured with the rheometer AR2000EX (the product of TA Instruments Japan Inc.).

In each of Comparative examples 1A, 2A, 3A, and 4A and Examples 1A, 2A, 3A, 4A, and 5A, a filling property and a water-resistant property were evaluated when the assembly 117 is filled with the thermoplastic resin with a filling pressure of 1.0 MPa or 6.0 MPa.

The filling property was evaluated on a scale of A, B, and C. Specifically, the evaluation A is the case (a visual check) that a leakage of the resin was not generated in the fitting portion (the fitting portion between the base metallic part and the ring cord and the fitting portion between the base metallic part and the front cover) while the assembly 117 was well filled with the thermoplastic resin. The evaluation B is the case (the visual check) that the leakage of the resin was generated in the fitting portion while the assembly 117 was filled with the thermoplastic resin. The evaluation C is the case (the visual check) that the assembly 117 was not filled with the thermoplastic resin.

The water-resistant property was evaluated on a scale of A and B. The proximity sensor obtained after the formation of the thermosetting resin portion 121 was subjected to a 100-cycle heat shock in which the proximity sensor was placed in environments of -25°C and 70°C, and subjected to an IP67 test. The evaluation A is the case that an insulating resistance value in the proximity sensor was larger than 50 MΩ, and the evaluation B is the case that an insulating resistance value in the proximity sensor was less than or equal to 50 MΩ. A non-defective determination (OK) was made in the case that the evaluation A was obtained for both the filling property and the water-resistant property, and a defective determination (NG) was made in the other cases.

In Comparative example 1A, the thermoplastic resin having a viscosity of 300 mPa•s was used as the filling resin. The filling property was the evaluation B, and the water-resistant property was the evaluation A. The defective determination (NG) was made for Comparative example 1A. Because the thermoplastic resin used in Comparative example 1A has the low viscosity beyond necessity, it is found that the leakage of the resin is generated while the remaining stress applied to the internal device can be relaxed.

In Example 1A, the thermoplastic resin having a viscosity of 500 mPa•s was used as the filling resin. In Example 2A, the thermoplastic resin having a viscosity of 2500 mPa•s was used as the filling resin. In Example 3A, the thermoplastic resin having a viscosity of 6000 mPa•s was used as the filling resin. In Example 4A, the thermoplastic resin having a viscosity of 8000 mPa•s was used as the filling resin. In Example 5A, the thermoplastic resin having a viscosity of 10000 mPa•s was used as the filling resin. In Examples 1A, 2A, 3A, 4A, and 5A, both the filling property and the water-resistant property were the evaluation A. The non-defective determination (OK) was made for Examples 1A, 2A, 3A, 4A, and 5A.

As to Example 5A, the experiment was performed many times under the condition of Example 5A, and sometimes the leakage of the resin was generated from the gate to degrade a yield ratio. Because the thermoplastic resin having a viscosity of 10000 mPa•s was used as the filling resin in Example 5A, it is considered that the yield ratio is degraded depending on the structure of the proximity sensor or a production facility unless the high pressure is applied to fill the assembly 117.

In Comparative example 2A, the thermoplastic resin having a viscosity of 13000 mPa•s was used as the filling resin. In Comparative example 3A, the thermoplastic resin having a viscosity of 15000 mPa•s was used as the filling resin. In Comparative example 4A, the thermoplastic resin having a viscosity of 30000 mPa•s was used as the filling resin. In Comparative examples 2A, 3A, and 4A, the filling property was the evaluation C, the water-resistant property was the evaluation B, and therefore the defective determination (NG) was made for Comparative examples 2A, 3A, and 4A. Because the thermoplastic resin used in Comparative examples 2A, 3A, and 4Ahave the high viscosity beyond necessity, it is found that not only the assembly 117 cannot be filled but also the sufficient water-resistant property is not obtained.

As can be seen from the result of Example 1, it is necessary that the thermoplastic resin used to form the thermoplastic resin portion 122 have the low viscosity in order to ensure the water-resistant property. This is because, with decreasing viscosity, a pressure loss in the case member during the filling decreases to maintain the thermoplastic resin portion at a suitable adhesion pressure of 0.1 MPa to 10 MPa with respect to the thermosetting resin portion. Accordingly, the thermoplastic resin suitably has a viscosity of 10000 mPa•s or less at a temperature of 190°C, preferably a viscosity of 8000 mPa•s or less from the viewpoint of easily filling the assembly 117 with the thermoplastic resin though the gate 81. During the filling, the pressure loss in the case member (the base metallic part 60) decreases with increasing inner diameter of the case member (the base metallic part 60). From this viewpoint, the cylindrical case member suitably has an inner diameter of 5 mm or more.

The use of the thermoplastic resin portion 122 can obtain the sufficient pressure for adhesion to the thermosetting resin portion 121 while suppressing loss of molding pressure (filling pressure). Even if thermal stress (repetitive linear expansion and shrinkage stress) is rapidly applied to a product, stress peel can be suppressed in the contact surface by ensuring the adhesion pressure, and high environment resistance can be ensured.

### [Experimental example 2]

Experimental example 2 performed with respect to the first embodiment will be described with reference to Fig. 28. The Experimental example 2 includes Examples 1B to 7B and Comparative examples 1B and 2B. In each of Examples 1B to 7B and Comparative examples 1B and 2B, the proximity sensor was prepared based on the processes in Figs. 15 to 20. The resin in Fig. 28 was used as the thermoplastic resin portion 122 in each of Examples 1B to 7B and Comparative examples 1B and 2B. Fig. 28 illustrates a composition of the resin used as the thermoplastic resin portion 122 and the hardness (Shore D) of the thermoplastic resin portion 122 for Examples 1B to 7B and Comparative examples 1B and 2B. The resin used herein as the thermoplastic resin portion 122 is a hot-melt resin.

After a predetermined test was performed to the proximity sensors which were prepared based on Examples 1B to 7B and Comparative examples 1B and 2B, the evaluation was made for the existence or non-existence of generation of damage or the kind of damage to the electronic component mounted on the proximity sensor and quality of the proximity sensor in a detection operation to detect the approach or presence of the detection target.

The generation of damage to the electronic component was evaluated on a scale of A to D. Specifically, the proximity sensor that is of a finished product prepared based on each of Examples 1B to 7B and Comparative examples 1B and 2B was subjected to the 100-cycle heat shock in which the proximity sensor was placed under the environments of -25°C and 70°C. The evaluation A is the case that damage to the electronic component was not generated. The evaluation B is the case that a crack was generated in a chip component mounted on the printed board 50. The evaluation C is the case that the crack was generated in the solder provided on the printed board 50. The evaluation D is the case that a characteristic fluctuation was generated in an IC mounted on the printed board 50.

As to the quality of the detection operation of the proximity sensor, for the proximity sensor subjected to the 100-cycle heat shock, the non-defective determination (OK) was made in the case that the approach or presence of the predetermined detection target can be detected, and the defective determination (NG) was made in the case that the approach or presence of the predetermined detection target cannot be detected.

In Example 1B, the thermoplastic resin used in the thermoplastic resin portion 122 was made of polyolefin, and had a hardness (Shore D) of 10. In Example 2B, the thermoplastic resin used in the thermoplastic resin portion 122 was made of polyolefin, and had a hardness (Shore D) of 29. In Example 3B, the thermoplastic resin used in the thermoplastic resin portion 122 was made of polyamide, and had a hardness (Shore D) of 35. In Example 4B, the thermoplastic resin used in the thermoplastic resin portion 122 was made of polyester, and had a hardness (Shore D) of 42.

In Example 5B, the thermoplastic resin used in the thermoplastic resin portion 122 was made of polyamide, and had a hardness (Shore D) of 45. In Example 6B, the thermoplastic resin used in the thermoplastic resin portion 122 was made of polyamide, and had a hardness (Shore D) of 53. In Example 7B, the thermoplastic resin used in the thermoplastic resin portion 122 was made of polyamide, and had a hardness (Shore D) of 60. In Examples 1B to 7B, damage to the electronic component was not generated (the evaluation A), and a predetermined condition was satisfied for the detection operation of the proximity sensor (the non-defective determination (OK)).

On the other hand, in Comparative example 1B, the thermoplastic resin used in the thermoplastic resin portion 122 was made of polyolefin, and had a hardness (Shore D) of 66. In Comparative example 1B, the generation of the solder crack and the characteristic fluctuation of the IC were observed (the evaluations C and D), and the predetermined condition was not satisfied for the detection operation of the proximity sensor (the defective determination (NG)).

In Comparative example 2B, the thermoplastic resin used in the thermoplastic resin portion 122 was made of polyester, and had a hardness (Shore D) larger than 70. In Comparative example 2B, the generation of the chip component crack, the generation of the solder crack, and the characteristic fluctuation of the IC were observed (the evaluations B, C, and D), and the predetermined condition was not satisfied for the detection operation of the proximity sensor (the defective determination (NG)).

As can be seen from the result of Example 2, it is necessary that the thermoplastic resin used to form the thermoplastic resin portion 122 have a hardness (Shore D) of 60 or less in order to reduce damage to the internal electronic component. The use of the thermoplastic resin having a hardness (Shore D) of 60 or less can reduce the stress applied to the internal device due to the heat and the pressure during the filling of the resin, eliminate the necessity for the reaction curing, and shorten the process tact time.

### [Second embodiment]

### (Entire configuration)

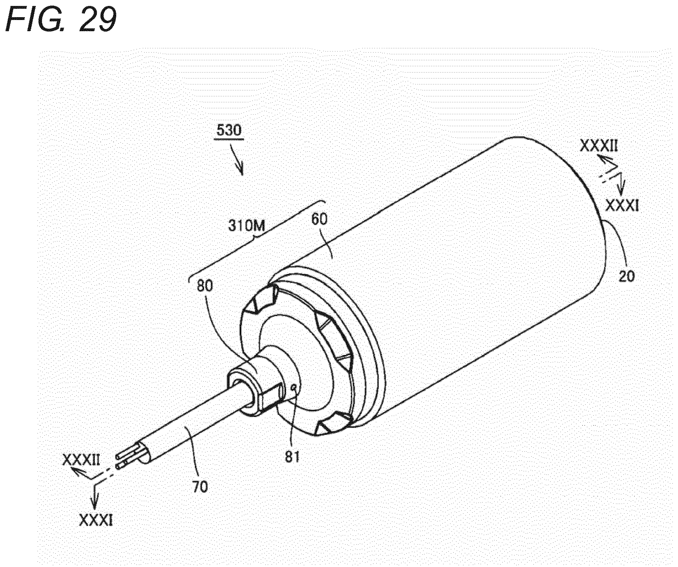

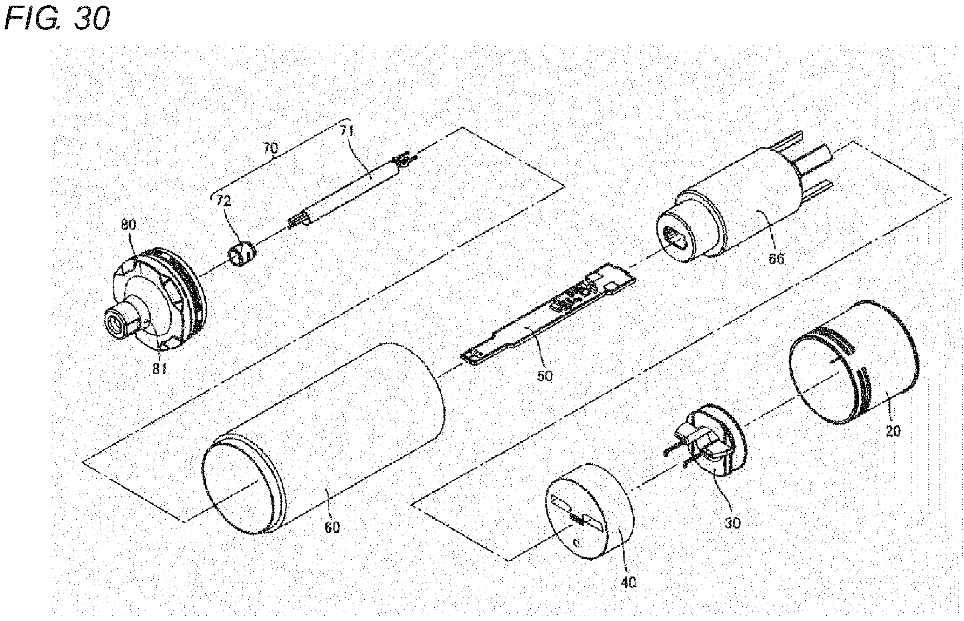

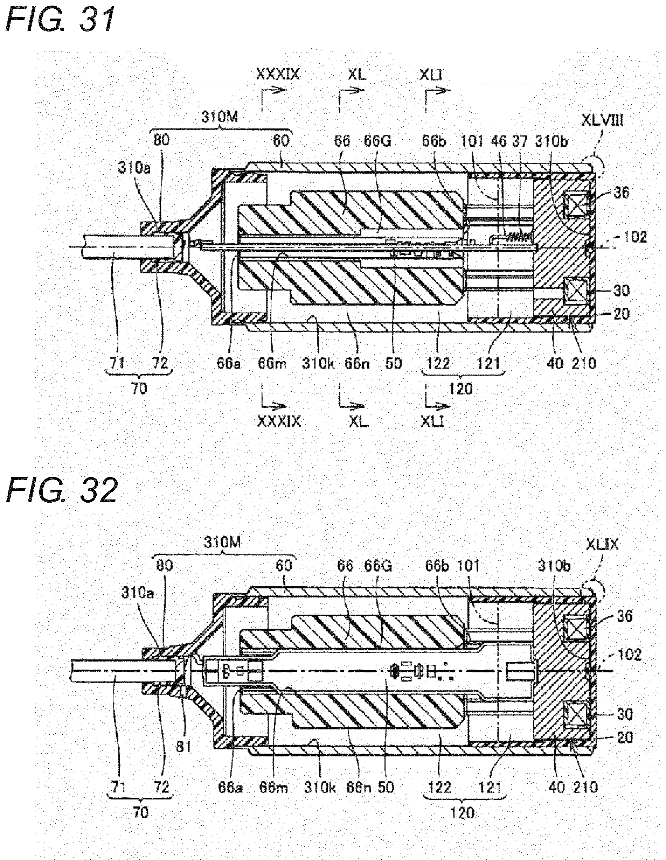

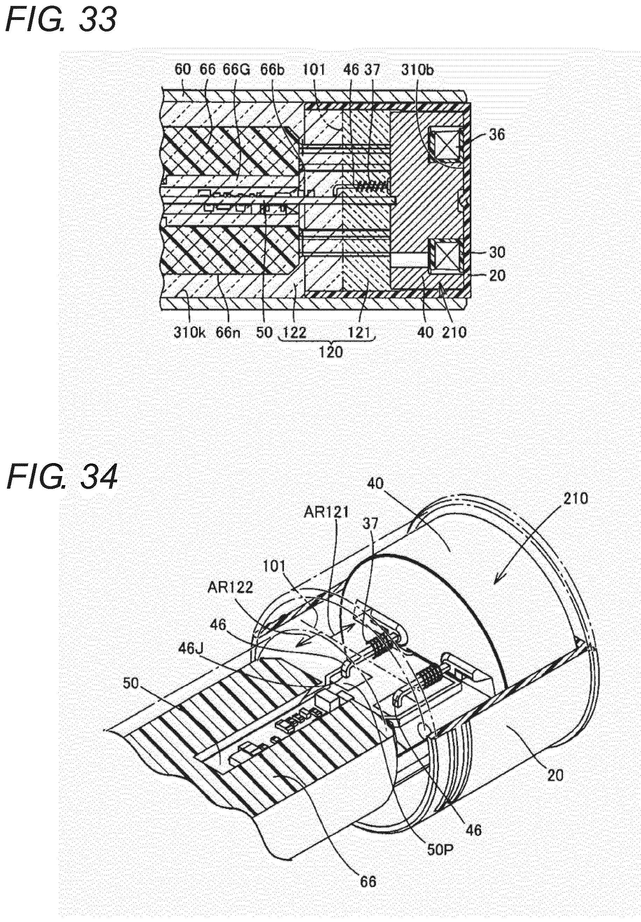

A proximity sensor 530 according to a second embodiment will be described with reference to Figs. 29 to 49. Fig. 29 is a perspective view illustrating the proximity sensor 530. Fig. 30 is an exploded perspective view illustrating the proximity sensor 530. Fig. 31 is a sectional view taken on a line XXXI-XXXI in Fig. 29. Fig. 32 is a sectional view taken on a line XXXII-XXXII in Fig. 29. Fig. 33 is an enlarged sectional view illustrating the neighborhood of the detection coil unit 210 included in the proximity sensor 530. Fig. 34 is a perspective view schematically illustrating the internal structure of the detection coil unit 210 included in the proximity sensor 530.

Referring to Figs. 29 to 34, the proximity sensor 530 is the induction-type proximity sensor that detects the approach or presence of the detection target by generating the magnetic field in the detection region. The conductive object is the detection target detected by the proximity sensor 530. Typically magnetic metals such as iron are the detection target detected by the proximity sensor 530, and nonmagnetic metals such as copper and aluminum may be the detection target.

The proximity sensor 530 has the columnar appearance that extends along the virtual center axis 102 (see Figs. 31 and 32). The proximity sensor 530 includes the detection coil unit 210 (see Figs. 31 to 34), the front cover 20 (the coil case), the printed board 50 (see Figs. 31 to 34), the base metallic part 60, the flow control member 66, the clamp 80, and a ring cord 70.

The detection coil unit 210 is provided as the detection unit that detects the approach or presence of the detection target. The detection coil unit 210 generates the magnetic field. The detection coil unit 210 is provided on the front end side of the proximity sensor 530 opposed to the detection region. The detection coil unit 210 is constructed by a combination of the core body 40, the electromagnetic coil 36 (see Figs. 31 to 33), the coil spool 30 (see Figs. 30 to 33), and the coil pin 46 (see Figs. 31 to 34).

The core body 40 is made of a material such as ferrite which has a high frequency property. The core body 40 has the function of enhancing the coil property of the detection coil unit 210 and of concentrating the magnetic flux on the detection region. The electromagnetic coil 36 is the coil wire, and is wound around the coil spool 30. The electromagnetic coil 36 is wound about the center axis 102. The center axis 102 also acts as the winding center axis for the electromagnetic coil 36.

The coil spool 30 (a spool body) is made of a resin having an electrical insulating property. The coil spool 30 is accommodated in the ring-like groove formed in the core body 40. The coil pin 46 is made of conductive metal. The coil pin 46 is supported by the coil spool 30. The coil pin 46 has the shape that extends from the detection coil unit 210 toward the side of the printed board 50. Using solder (not illustrated), the extending end of the coil pin 46 is connected to the pattern 50P (see Fig. 34) formed on the printed board 50.

The leading end 37 of the electromagnetic coil 36 drawn from the outer circumference of the coil spool 30 is wound around the root portion of the coil pin 46 extending from the detection coil unit 210. The electromagnetic coil 36 and the printed board 50 are electrically connected to each other through the coil pin 46 and the solder (not illustrated).

The detection coil unit 210 is accommodated in the front cover 20 (the coil case). The front cover 20 is made of resin. The front cover 20 is made of a thermoplastic resin. For example, the front cover 20 is made of a material, such as PBT (polybutylene terephthalate) which exerts a good adhesion property with respect to the thermoplastic resin forming a thermoplastic resin portion 122. The front cover 20 is provided as the front end cover in which the detection coil unit 210 is accommodated. The front cover 20 closes the front end of the base metallic part 60 having the cylindrical shape. The front cover 20 is provided mainly in order to shut off and protect the detection coil unit 210 from the external atmosphere.

The front cover 20 has the cylindrical shape with a bottom. The front cover 20 extends cylindrically with the center axis 102 as the center, and one end of the front cover 20 is closed while the other end is opened. The end surface on the closed end side of the front cover 20 constitutes the detection surface of the proximity sensor 530.

The printed board 50 has the elongated planar shape. The printed board 50 extends with the center axis 102 as the longitudinal direction. Various electronic components (not illustrated) such as a transistor, a diode, a resistor, and a capacitor are mounted on the printed board 50. The electronic components also include one that is electrically connected to the detection coil unit 210. The light emitting diode (LED) (not illustrated) is mounted on the printed board 50. The light emitting diodes are provided in the surface and the back side of the printed board 50 to act as the light emitting unit that indicates a detection state.

The base metallic part 60 is provided as the body case in which the electronic components such as the transistor, the diode, the resistor, and the capacitor are accommodated. The base metallic part 60 constitutes an outline of the proximity sensor 530 on the outer circumference of the center axis 102. The base metallic part 60 has the cylindrical shape that extends with the center axis 102 as the center. The base metallic part 60 extending along the center axis 102 is opened at both ends. The front cover 20 is inserted in one of the opened ends of the base metallic part 60, whereby the front cover 20 is fixed to the base metallic part 60. For example, the base metallic part 60 has an inner diameter of at least 5 mm.

The base metallic part 60 is made of metal. A thread to be used to fix the proximity sensor 530 to the external facility is formed on the outer circumferential surface of the base metallic part 60. The proximity sensor 530 of the embodiment is what is called a sealed type proximity sensor in which the base metallic part 60 is disposed on the outer circumference of the detection coil unit 210. The proximity sensor 530 may be applied to what is called a non-sealed type proximity sensor in which the base metallic part 60 is disposed at a position deviated in the axial direction of the center axis 102 from the outer circumference of the detection coil unit 210.

The clamp 80 is provided as a connection member that is connected to the base metallic part 60 from the rear end side of the proximity sensor 530. The clamp 80 is connected to the rear end of the base metallic part 60 having the cylindrical shape. The clamp 80 is inserted in the rear end of the base metallic part 60. The clamp 80 extends cylindrically with the center axis 102 as the center while being integral with the base metallic part 60. The base metallic part 60 and the clamp 80 constitute a cylindrical case 310M that extends cylindrically with the center axis 102 as the center. The printed board 50 and the electronic components mounted on the printed board 50 are accommodated in the cylindrical case 310M.

The light emitting diode mounted on the printed board 50 is positioned in the clamp 80. The clamp 80 is made of resin. The clamp 80 is made of a transparent or translucent resin such that the emission of the light emitting diode can visually be recognized from the outside of the proximity sensor 530. For example, the clamp 80 is made of polyamide. The gate 81 is formed in the clamp 80. The gate 81 is provided as a through-hole through which the resin is injected into the cylindrical case 310M in producing the proximity sensor 530.

The ring cord 70 is electrically connected to the printed board 50 in the cylindrical case 310M. The ring cord 70 is drawn from the rear end side of the cylindrical case 310M. The ring cord 70 is provided as a rear cover that closes the rear end of the cylindrical case 310M.

The ring cord 70 includes a cable 71 and a ring member 72. The ring member 72 is provided so as to cover the end portion of the cable 71 in the cylindrical case 310M. The ring member 72 ensures a joining property between the cable 71 and a sealing resin 120 provided in the cylindrical case 310M. For example, the ring member 72 is made of PBT (polybutylene terephthalate). For example, the cable 71 is coated with polyvinyl chloride.

In the cylindrical case 310M, the sealing resin 120 is formed by the injection of the resin. In the proximity sensor 530, a tubular case member in which the detection coil unit 210 and the printed board 50 are accommodated is constructed by the cylindrical case 310M, the ring cord 70, and the front cover 20. An inner surface 310k of the case member includes the inner surface of the base metallic part 60, the inner surface of the clamp 80, and the inner surface of the front cover 20. A first end portion 310a is formed in the inner surface 310k on the side of the clamp 80, and a second end portion 310b is formed in the inner surface 310k on the side of the front cover 20.

In the inner surface of the clamp 80, the first end portion 310a is located at a circumferential edge of the opening in which the cable 71 is press-fitted. In the inner surface of the front cover 20, the second end portion 310b is located in the front in the insertion direction of the core body 40. The second end portion 310b that is of the case member is closed by the front cover 20. The inner surface 310k of the case member in which the detection coil unit 210 and the printed board 50 are accommodated has the shape extending from the first end portion 310a toward the second end portion 310b (or the shape extending from the second end portion 310b toward the first end portion 310a).

The sealing resin 120 is provided such that a space of the case member surrounded by the cylindrical case 310M and the front cover 20 and the ring cord 70, which close the front and rear ends of the cylindrical case 310M, is filled with the sealing resin 120. The sealing resin 120 seals the detection coil unit 210 accommodated in the front cover 20 and the printed board 50 and electronic components which are accommodated in the cylindrical case 310M.

### (Sealing resin 120)

The sealing resin 120 includes the thermosetting resin portion 121 and the thermoplastic resin portion 122. The thermosetting resin portion 121 is made of a thermosetting resin, and seals the detection coil unit 210 (the core body 40, the electromagnetic coil 36, and the coil spool 30). The thermoplastic resin portion 122 is made of a thermoplastic resin, and formed in the portion other than the thermosetting resin portion 121 in the case member (the cylindrical case 310M, the ring cord 70, and the front cover 20) to seal the printed board 50 and the electronic components. Although described in detail later, the thermoplastic resin having a hardness (Shore D) of 60 or less is selected to form the thermoplastic resin portion 122. Although described in detail later, the thermoplastic resin portion 122 is formed by solidification of the thermoplastic resin injected through the gate 81 after the thermoplastic resin flows in a flow path (hereinafter also referred to as a first flow path or an external flow path) formed between the inner surface 310k of the case member and an outer surface 66n of an flow control member 66 and spreads in an internal flow path 66G (hereinafter also referred to as a second flow path) constructed by a tubular internal space of the flow control member 66.

The thermosetting resin portion 121 and the thermoplastic resin portion 122 are provided so as to have the boundary in the front cover 20 indicated by the alternate long and two short dashes line 101 in Figs. 31 to 34. Referring to Fig. 34, the thermosetting resin portion 121 is formed on the side of the direction indicated by the arrow AR121 when viewed from the alternate long and two short dashes line 101, and the thermoplastic resin portion 122 is formed on the side of the direction indicated by the arrow AR122 when viewed from the alternate long and two short dashes line 101.

The thermosetting resin portion 121 seals part of the coil pin 46 (portion on the root side of the coil pin 46) while sealing at least the core body 40, the electromagnetic coil 36, and the coil spool 30. In the coil pin 46, the portion that is not sealed by the thermosetting resin portion 121 is sealed by the thermoplastic resin portion 122. In the coil pin 46, the portion (on the side of a leading end 46J) extending from the front of the portion around which the leading end 37 of the electromagnetic coil 36 (the coil wire) is wound is sealed by the thermoplastic resin portion 122 (see Fig. 33). In the coil pin 46, the portion soldered to the pattern 50P of the printed board 50 is sealed by the thermoplastic resin portion 122. Alternatively, in the coil pin 46, the portion (on the side of the leading end 46J) extending from the front of the portion around which the leading end 37 of the electromagnetic coil 36 (the coil wire) is wound may be sealed by the thermosetting resin portion 121. In this case, in the coil pin 46, the portion soldered to the pattern 50P of the printed board 50 is sealed by the thermosetting resin portion 121.

The thermoplastic resin that can be molded at low temperature and at low pressure is suitably used to form the thermoplastic resin portion 122. At least one selected from a group consisting of polyolefin, polyester, and polyamide can be cited as an example of the thermoplastic resin. Various additives such as a flame retardant, an organic/inorganic filler, a plasticizer, a colorant, and an antioxidant may be contained in the thermoplastic resin used to form the thermoplastic resin portion 122. The use of the thermoplastic resin having a hardness (Shore D) of 60 or less can reduce the stress applied to the internal device due to the heat and the pressure during the filling of the resin, eliminate the necessity for the reaction curing, and shorten the process tact time.

The molding machine in which the resin filling pressure is arbitrarily adjusted in the range of 0.1 MPa to 10 MPa may be used as one that fills the thermoplastic resin portion 122 with the thermoplastic resin. The resin filling pressure may be set in the range of 0.1 MPa or more, more preferably the range of 1 MPa or more from the viewpoint of the property of filling the detailed structure of the proximity sensor 530 with the resin. The resin filling pressure may be set in the range of 10 MPa or less, more preferably the range of 6 MPa or less from the viewpoint of suppressing damage to the internal component.

An epoxy resin can be cited as a typical example of the thermosetting resin used to form the thermosetting resin portion 121. Preferably the thermosetting resin portion 121 has the small fluctuation in resin stress (the stress relaxation) applied to the detection coil unit 210. Preferably the thermosetting resin portion 121 has an elastic modulus of 800 MPa or more at room temperature. Various additives such as a flame retardant, an organic/inorganic filler, a plasticizer, a colorant, and an antioxidant may be contained in the thermosetting resin used to form the thermosetting resin portion 121. The sealing resin 120 is not limited to the two-stage segmentation structure including the thermosetting resin portion 121 and the thermoplastic resin portion 122, but the sealing resin 120 may have a segmentation structure of at least three stages.

The viscosity of the thermoplastic resin portion 122 ranges preferably from 500 mPa•s to 10000 mPa•s when being measured with the rheometer AR2000EX (a product of TA Instruments Japan Inc.) at a shearing speed of 10 (1/s) and at a temperature of 190°C. The viscosity of the thermoplastic resin portion 122 ranges more preferably from 500 mPa•s to 8000 mPa•s when being measured with the rheometer AR2000EX (a product of TA Instruments Japan Inc.) at a shearing speed of 10 (1/s) and at a temperature of 190°C.

### (Flow control member 66)

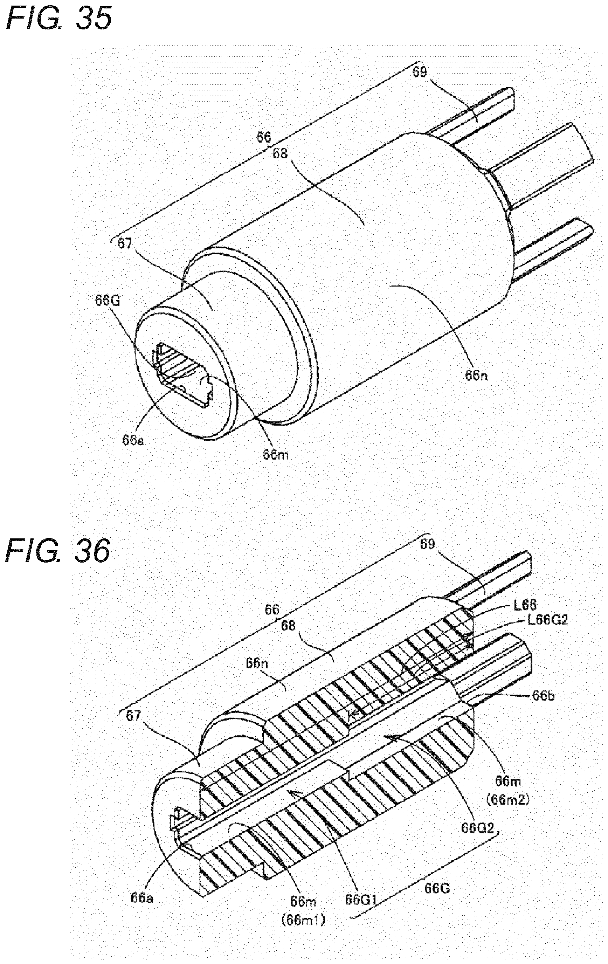

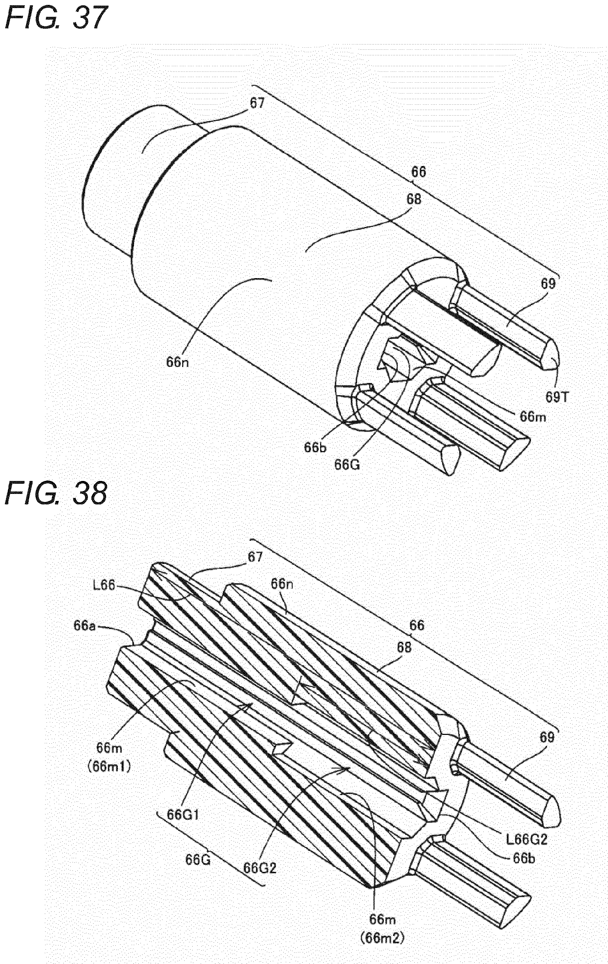

The flow control member 66 disposed inside the base metallic part 60 (see Figs. 31 to 33) will be described in detail with reference to Figs. 35 to 38. Fig. 35 is a perspective view illustrating the flow control member 66. Fig. 36 is a sectional perspective view corresponding to the flow control member 66 in Fig. 35. Fig. 37 is another perspective view illustrating the flow control member 66. Fig. 38 is a sectional perspective view corresponding to the flow control member 66 in Fig. 37.

The flow control member 66 includes a small diameter portion 67, a large diameter portion 68, and four pillar portions 69. The small diameter portion 67 and the large diameter portion 68 have tubular shapes, and are coaxially formed. When an outer surface 66n of the small diameter portion 67 and the large diameter portion 68 are viewed in the axial direction, the outer surface 66n of the sectional shape has a precise circle shape in section. The outer diameter of the small diameter portion 67 is smaller than that of the large diameter portion 68. The small diameter portion 67 is shorter than the large diameter portion 68 in the axial direction.

A first opening 66a is formed in the end portion of the small diameter portion 67, and a second opening 66b is formed in the end portion of the large diameter portion 68. The flow control member 66 has a tubular shape extending from the first opening 66a toward the second opening 66b. The flow control member 66 is disposed in the case member such that the first opening 66a is disposed on the side of the first end portion 310a (see Fig. 31), and such that the second opening 66b is disposed on the side of the second end portion 310b (see Fig. 31). The flow control member 66 is disposed coaxially with the inner surface 310k of the case member.

An internal flow path 66G (the second flow path) is provided radially inside of the small diameter portion 67 and the large diameter portion 68. The internal flow path 66G is the internal space of the flow control member 66, which is surrounded by an inner surface 66m of the small diameter portion 67 and the large diameter portion 68. The printed board 50 (see Fig. 31) is disposed in the internal flow path 66G. The internal flow path 66G includes a first internal flow path 66G1 having a substantially rectangular solid shape and a second internal flow path 66G2 having a substantially rectangular solid shape. The first internal flow path 66G1 communicates the first opening 66a and second internal flow path 66G2 with each other. The second internal flow path 66G2 communicates the first internal flow path 66G1 and the second opening 66b with each other.

In the first internal flow path 66G1, the first opening 66a is formed on the opposite side to the side continued to the second internal flow path 66G2. In the second internal flow path 66G2, the second opening 66b is formed in the end portion on the opposite side to the side continued to the first internal flow path 66G1. The second opening 66b is continued to the first internal flow path 66G1, and has a flow path cross-section area larger than that of the first internal flow path 66G1. The second opening 66b is formed such that an opening area of the second opening 66b is larger than that of the first opening 66a. An inner surface 66m1 of the inner surface 66m constitutes the first internal flow path 66G1, and an inner surface 66m2 of the inner surface 66m constitutes the second internal flow path 66G2. In the state in which the proximity sensor 530 is assembled, the gate 81 provided in the clamp 80 is located between the first end portion 310a and the first opening 66a of the flow control member 66 in the direction of the center axis 102.

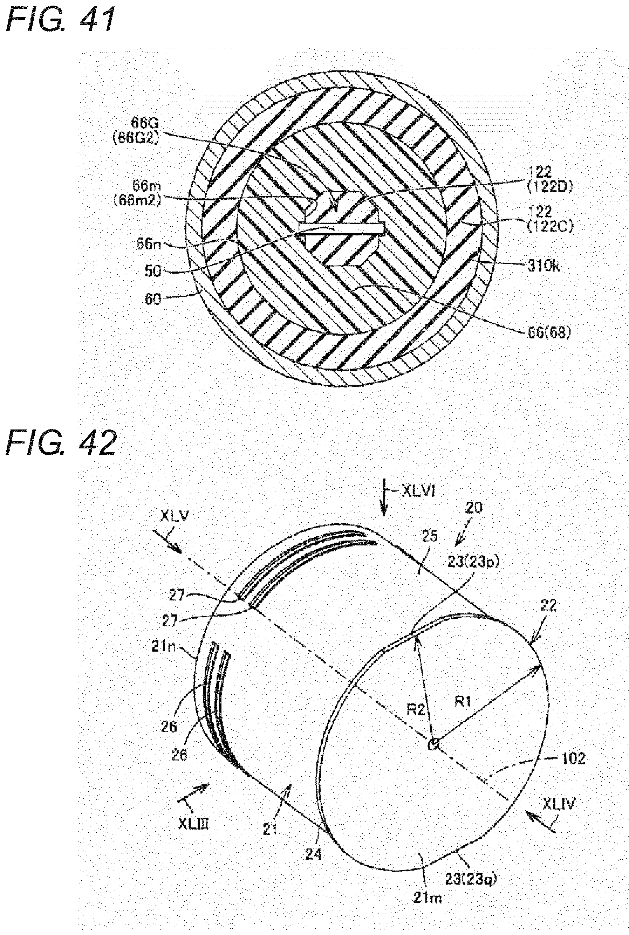

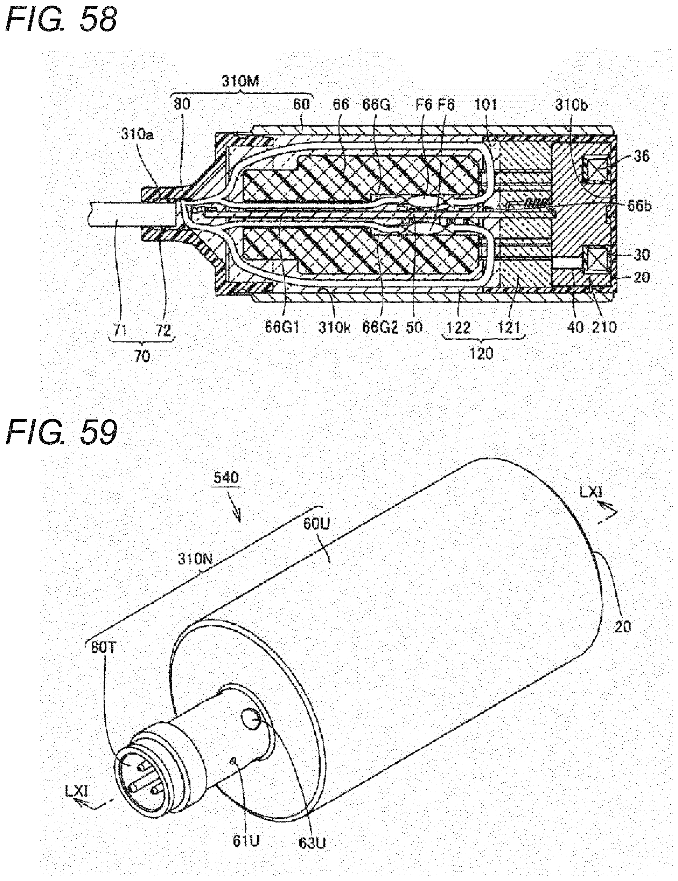

In the second embodiment, the second internal flow path 66G2 is a region satisfying a relationship of C : D = 1 to 7 : 1 (described in detail later with reference to Figs. 41 and 58), and the second internal flow path 66G2 extends toward the side of the first opening 66a with the second opening 66b as a starting point. In the extending direction of the flow control member 66 (in the second embodiment, extending direction of the center axis 102), a length L66G2 of the second internal flow path 66G2 ranges from 10% to 70% with respect to a length L66 between the first opening 66a and the second opening 66b.

The four pillar portions 69 are provided on the opposite side to the small diameter portion 67 when viewed from the large diameter portion 68. The four pillar portions 69 are disposed at intervals of 90° around the second opening 66b, and extend in parallel with the axial directions of the small diameter portion 67 and the large diameter portion 68. In the state in which the flow control member 66 is disposed inside the base metallic part 60 (see Fig. 31), an end portion 69T (see Fig. 37) of the pillar portion 69 comes close to or abuts on the end surface of the core body 40 (see Fig. 31)

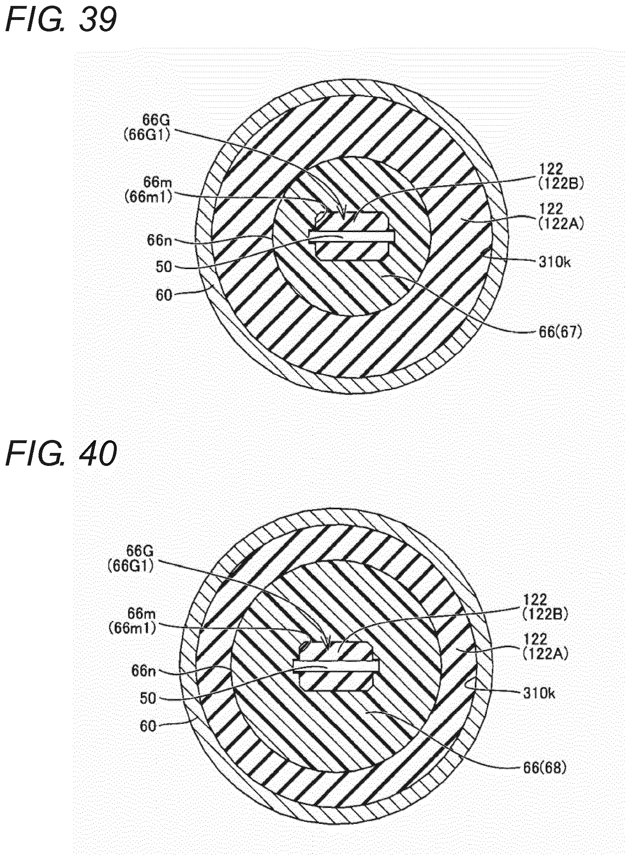

Fig. 39 is a sectional view taken on a line XXXIX-XXXIX in Fig. 31. Fig. 39 is a sectional view corresponding to the small diameter portion 67 (see Fig. 35) in the flow control member 66. Fig. 40 is a sectional view taken on a line XL-XL in Fig. 31. Fig. 40 is a sectional view corresponding to the large diameter portion 68 (see Fig. 35) and the first internal flow path 66G1 in the flow control member 66. Fig. 41 is a sectional view taken on a line XLI-XLI in Fig. 31. Fig. 41 is a sectional view corresponding to the large diameter portion 68 (see Fig. 35) and the second internal flow path 66G2 in the flow control member 66.

Referring to Figs. 39 to 41, as described above, the sealing resin 120 is provided such that the space of the case member surrounded by the cylindrical case 310M and the front cover 20 and the ring cord 70, which close the front and rear ends of the cylindrical case 310M, is filled with the sealing resin 120. In forming the thermoplastic resin portion 122 of the sealing resin 120 in the case member, the case member is filled with the thermoplastic resin through the gate 81 provided in the case member.

The thermoplastic resin portion 122 of the sealing resin 120 is formed by the solidification of the thermoplastic resin injected through the gate 81 after the thermoplastic resin spreads in the external flow path or the first flow path between the inner surface 310k of the case member (the base metallic part 60) and the outer surface 66n of the flow control member 66 and spreads in the internal flow path 66G or the second flow path inside the flow control member 66 through the first opening 66a and the second opening 66b.

The sectional shape orthogonal to the extending direction (in the second embodiment, the extending direction of the center axis 102) of the flow control member 66 is referred to as a first sectional shape. In the second embodiment, one of or all the shapes illustrated in Figs. 39 to 41 are obtained as the first sectional shape. In the first sectional shape, it is assumed that A is an area of the sealing resin 120 (a thermoplastic resin portion 122A) formed in the first flow path or the external flow path between the inner surface 310k of the case member (the base metallic part 60) and the outer surface 66n of the flow control member 66. In the first sectional shape, it is assumed that B is an area of the sealing resin 120 (a thermoplastic resin portion 122B) formed in the internal flow path 66G inside the flow control member 66.

In the second embodiment, the sectional shapes of the external flow path (the first flow path) and the internal flow path 66G (the second flow path) are formed such that the resin flowing in and filling the external flow path through the gate 81 reaches the second opening 66b earlier than the resin flowing in and filling the internal flow path 66G through the gate 81. For example, the configuration can be implemented as follows.

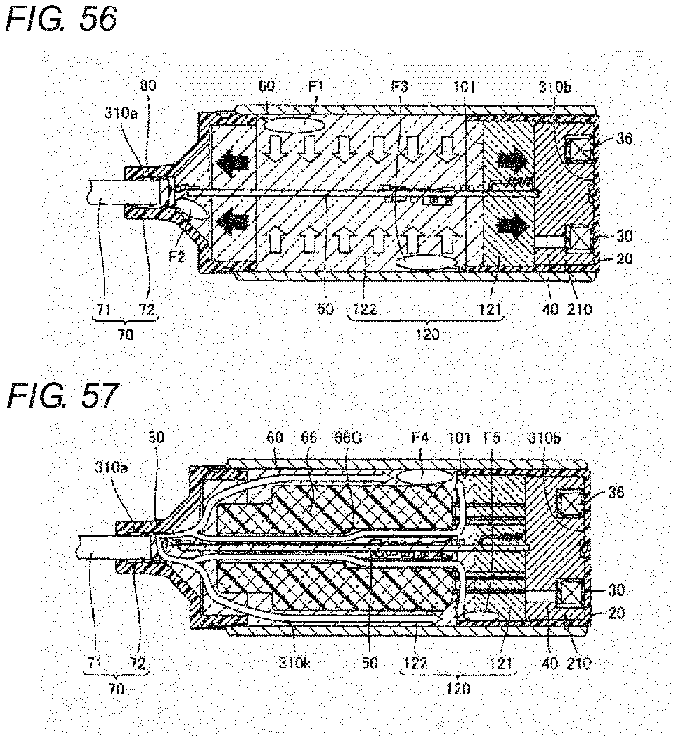

In the second embodiment, the sealing resin 120 (the thermoplastic resin portion 122A) formed between the inner surface 310k of the case member (the base metallic part 60) and the outer surface 66n of the flow control member 66 has the thickness of 2 mm to 4 mm, and a relationship of A : B = 3 to 37 : 1 holds for the first sectional shape of one of or all the positions in the extending direction of the flow control member 66. In other words, the sealing resin 120 (the thermoplastic resin portion 122A) formed between the inner surface 310k of the case member (the base metallic part 60) and the outer surface 66n of the flow control member 66 has the thickness of 2 mm to 4 mm, and the thermoplastic resin portion 122A formed outside the flow control member 66 has the area (an area ratio) of 3 to 37 when the thermoplastic resin portion 122B formed in the internal flow path 66G of the flow control member 66 has the area of 1. The detailed action and effect of the configuration are described later with reference to Figs. 56 to 58.

### (Front cover 20 and base metallic part 60)

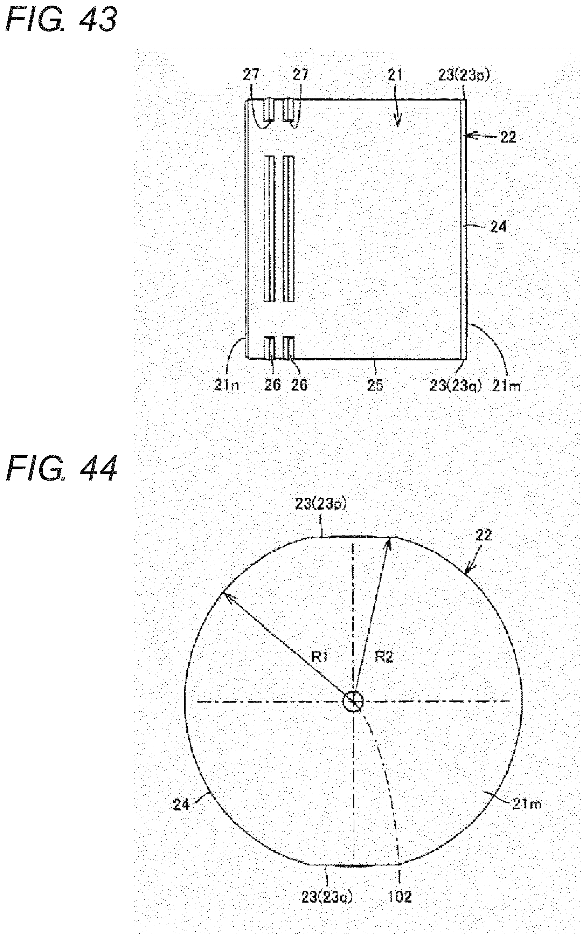

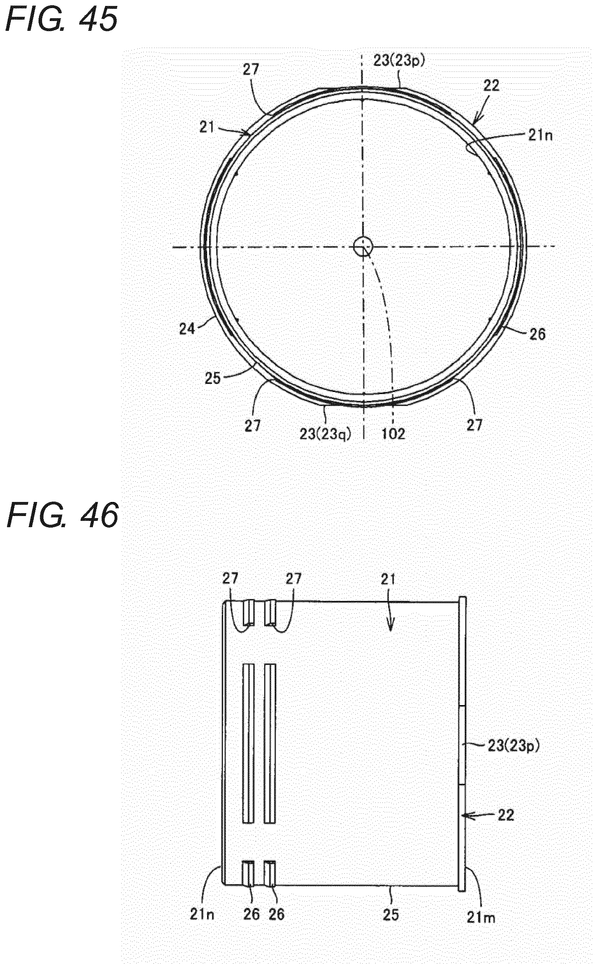

Fig. 42 is a perspective view illustrating the front cover 20. Fig. 43 is a view illustrating the front cover 20 when the front cover 20 is viewed in the direction indicated by an arrow XLIII in Fig. 42. Fig. 44 is a view illustrating the front cover 20 when the front cover 20 is viewed in the direction indicated by an arrow XLIV in Fig. 42. Fig. 45 is a view illustrating the front cover 20 when the front cover 20 is viewed in the direction indicated by an arrow XLV in Fig. 42. Fig. 46 is a view illustrating the front cover 20 when the front cover 20 is viewed in the direction indicated by an arrow XLVI in Fig. 42. In the drawings, the center axis 102 is indicated when the front cover 20 is assembled in the proximity sensor 530.

Referring to Figs. 42 to 46, the front cover 20 includes the cylindrical portion 21, the rib-shape portion 26, and the guard portion 22 as structural components. The cylindrical portion 21 includes the closed end 21m in one of the end portions of the cylindrical portion 21 and the opened end 21n in the other end portion of the cylindrical portion 21. The space in which the detection coil unit 210 is accommodated is formed in the cylindrical portion 21. The cylindrical portion 21 includes the outer circumferential surface 25.

The rib-shape portion 26 is projected from the outer circumferential surface 25 of the cylindrical portion 21. The air vent 27 is formed in the rib-shape portion 26. The guard portion 22 is provided on the side of the closed end 21m of the cylindrical portion 21. The guard portion 22 has a circular shape with the center axis 102 as the center, and a diameter of the guard portion 22 is larger than that of the outer circumferential surface 25 of the cylindrical portion 21. The guard portion 22 includes the outer circumferential edge 24.

The notch 23 is formed in the guard portion 22. The notch 23 is formed such that a length from the center axis 102 to the outer circumferential edge 24 of the guard portion 22 is not uniform around the center axis 102. As illustrated in Figs. 42 and 44, the guard portion 22 has the length R1 from the center axis 102 to the outer circumferential edge 24 of the guard portion 22 at the position where the notch 23 is not formed, and has the length R2 from the center axis 102 to the outer circumferential edge 24 of the guard portion 22 at the position where the notch 23 is formed. The length R2 is the variable value smaller than the length R1 (R2 < R1).

The notch 23 is provided such that the outer circumferential edge 24 of the guard portion 22 is liner when viewed in the direction of the center axis 102. The notch 23 is provided such that the outer circumferential edge 24 of the guard portion 22 is a tangent to the outer circumferential surface 25 of the cylindrical portion 21 when viewed in the direction of the center axis 102. The notch 23 includes the notch 23p and the notch 23q. The notch 23p and the notch 23q are provided 180 degrees apart in the circle having the center axis 102 as the center.

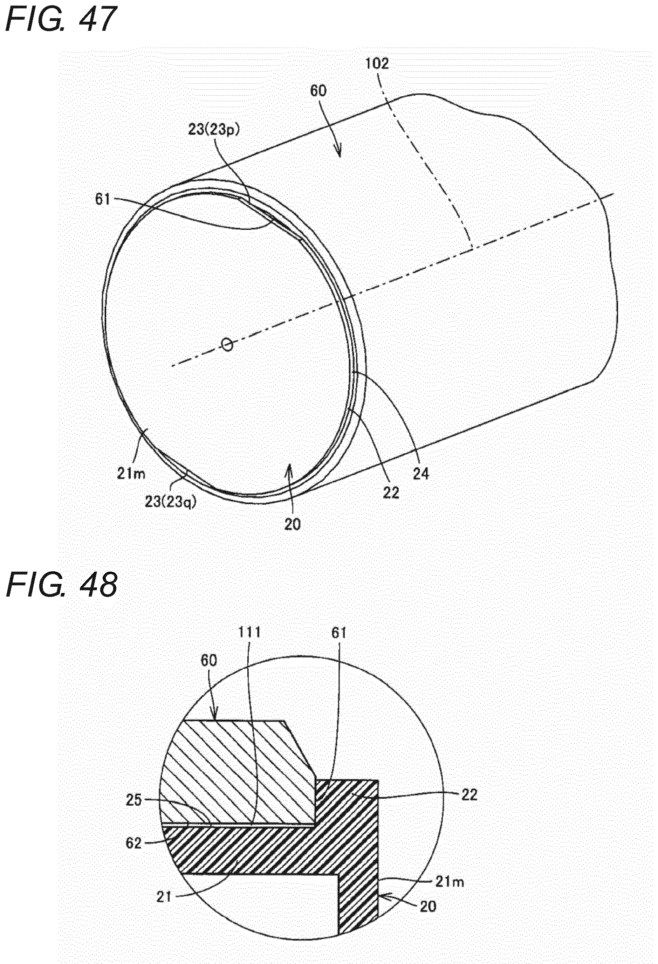

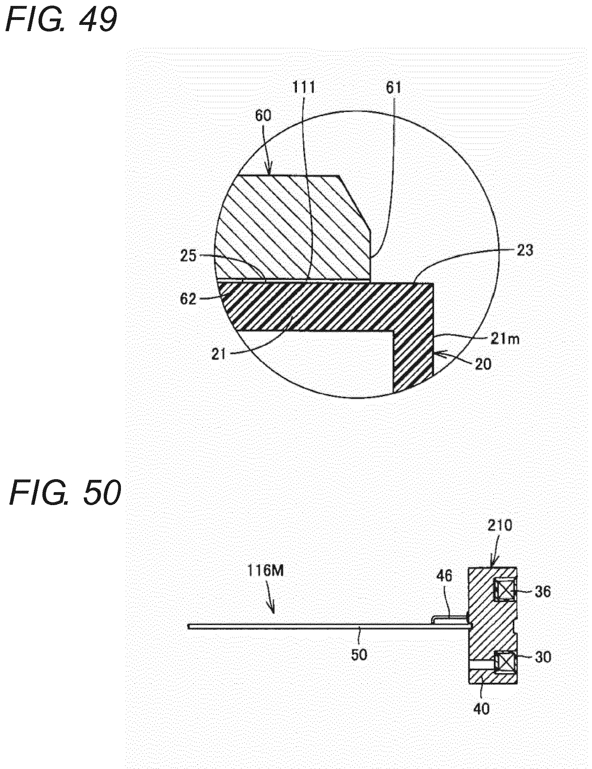

Fig. 47 is a perspective view illustrating the front end portion of the proximity sensor 530 (see Fig. 29). Fig. 48 is an enlarged sectional view illustrating a range surrounded by an alternate long and two short dashes line XLVIII in Fig. 31. Fig. 49 is an enlarged sectional view illustrating a range surrounded by an alternate long and two short dashes line XLIX in Fig. 32.

Referring to Figs. 31, 32, and 47 to 49, the base metallic part 60 is fitted on the outer circumference of the cylindrical portion 21 from the side of the end 21n (see Fig. 42), and the base metallic part 60 is assembled in the front cover 20 while abutting on the guard portion 22. The base metallic part 60 includes a front surface 61 disposed on the front end side of the proximity sensor 530. The guard portion 22 of the front cover 20 and the front surface 61 of the base metallic part 60 are in contact with each other. The base metallic part 60 abuts on the guard portion 22 to regulate the movement of the front cover 20 onto the rear end side of the proximity sensor 530.

In the base metallic part 60, the rib-shape portion 26 is compressively deformed by the base metallic part 60. The front cover 20 is fixed to the base metallic part 60 by the press-fitting. The gap 111 is formed between the outer circumferential surface 25 of the front cover 20 and the base metallic part 60. The gap 111 is set to a minute size enough for the resin, with which the cylindrical case 310M is filled, not to invade into the gap 111 during the production of the proximity sensor 530. For example, the gap 111 has a size of 0.3 mm or less.

Fig. 49 illustrates the section at the position where the notch 23 is provided in the guard portion 22. The notch 23 is provided to expose the gap 111 between the outer circumferential surface 25 of the front cover 20 and the base metallic part 60. The base metallic part 60 abuts on the guard portion 22, whereby the gap 111 is closed by the guard portion 22 while the gap 111 is communicated with the external space at the position where the notch 23 is provided.

### (Producing method)

A method for producing the proximity sensor 530 (see Fig. 29) will be described with reference to Figs. 50 to 55. Referring to Fig. 50, a sub-assembly 116M including the detection coil unit 210 and the printed board 50 is assembled. Specifically, the printed board 50 is connected to the core body 40 while the core body 40 and the coil spool 30, around which the electromagnetic coil 36 is wound, is combined. The leading end of the coil pin 46 is soldered to the surface (the pattern 50P in Fig. 34) of the printed board 50 to electrically connect the electromagnetic coil 36 and the printed board 50.

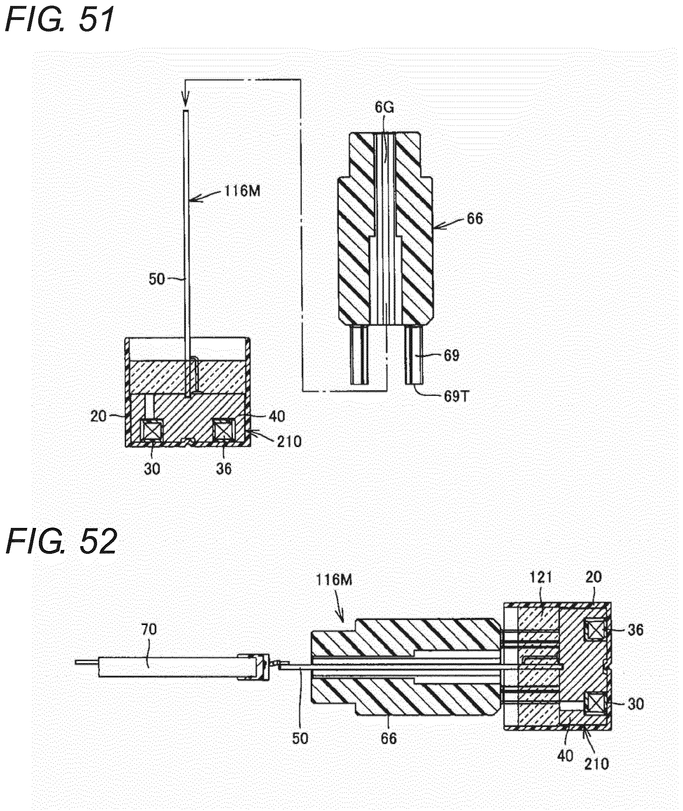

Referring to Fig. 51, the front cover 20 and the flow control member 66 are assembled in the sub-assembly 116M. Specifically, the front cover 20 is filled with the thermosetting resin as a primary injection resin. The sub-assembly 116M is inserted and disposed in the front cover 20 from the side of the detection coil unit 210 that detects the approach or presence of the detection target, thereby dipping the detection coil unit 210 in the thermosetting resin in the front cover 20. Then, the pillar portion 69 is dipped in the thermosetting resin in the front cover 20 while the printed board 50 is inserted in the internal flow path 66G of the flow control member 66 until the end portion 69T of the pillar portion 69 comes close to or abuts on the core body 40. The thermosetting resin in the front cover 20 is cured by the heating. The four pillar portions 69 are provided in the flow control member 66, so that the flow control member 66 can be fixed to the front cover 20 while the pillar portions 69 are partially dipped in the thermosetting resin without overflowing from the front cover 20.

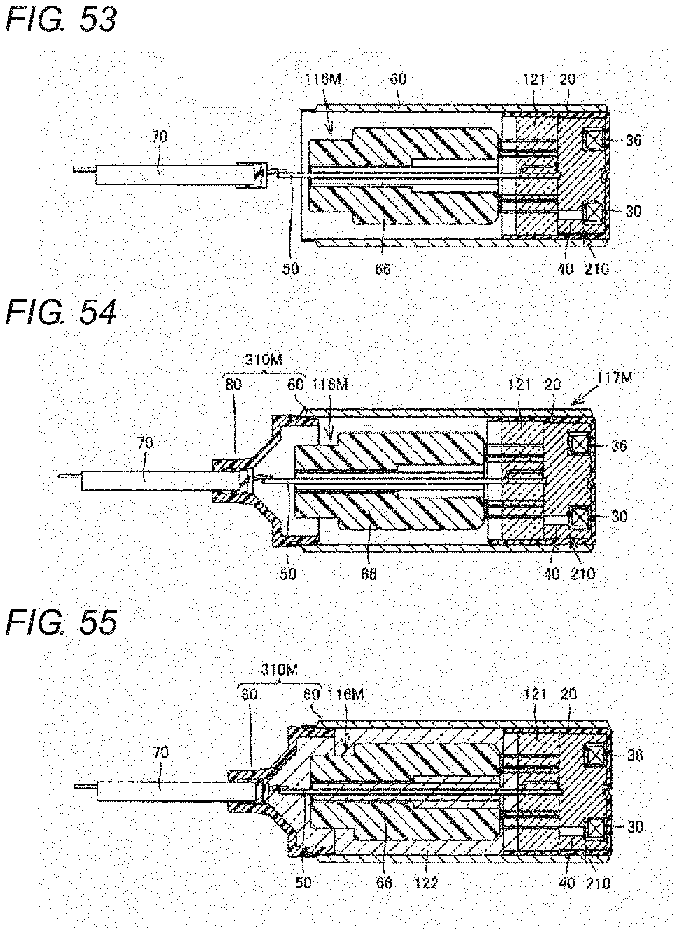

Referring to Fig. 52, the ring cord 70 is assembled in the sub-assembly 116M. Specifically, the leading end of the cable of the ring cord 70 is soldered onto the surface of the printed board 50. Referring to Fig. 53, the base metallic part 60 is assembled in the front cover 20. Specifically, the ring cord 70 and the printed board 50 are sequentially inserted from the front end side of the base metallic part 60, and the front cover 20 is press-fitted in the front end side of the base metallic part 60.

Referring to Fig. 54, the clamp 80 is assembled in the base metallic part 60. Specifically, the ring cord 70 is inserted from the front end side of the clamp 80, and the clamp 80 is press-fitted in the rear end side of the base metallic part 60. Then the base metallic part 60 and the clamp 80 are fixed to each other using fixing methods such as gouging, swaging, adhesion, and welding. Therefore, an assembly 117M is obtained. The process of fixing the base metallic part 60 and the clamp 80 to each other may be performed after the process of filling the proximity sensor with the secondary filling resin subsequent thereto.

Referring to Fig. 55, the cylindrical case 310M including the base metallic part 60 and the clamp 80 is filled with the thermoplastic resin as the secondary filling resin. More specifically, the assembly 117M obtained through the process is set in a die using a positioning jig. The high-temperature resin is injected into the cylindrical case 310M through the gate 81 (see Figs. 29 and 32). The gate 81 is provided on the side (between the first end portion 310a and the first opening 66a of the flow control member 66) of the first end portion 310a from the portion in which the first opening 66a of the flow control member 66 is located in the extending direction of the center axis 102.

The high-temperature resin is branched into the resin flowing into the internal flow path 66G (the second flow path) of the flow control member 66 from the side of the first end portion 310a and the resin flowing into the external flow path or the first flow path between the outer surface 66n of the flow control member 66 and the inner surface 310k of the case member. The branched resins finally join together in the neighborhood of the front cover 20, and the internal space of the case member is substantially filled with the resin while an air bubble is confined in the resin. As described above, the resin flowing in and filling the external flow path through the gate 81 reaches the second opening 66b earlier than the resin flowing in and filling the internal flow path 66G through the gate 81. The thermoplastic resin portion 122 is formed by cooling and solidifying the thermoplastic resin. The printed board 50 and various electronic components in the cylindrical case 310M are sealed by the resin. The proximity sensor 530 in Fig. 29 is completed through the above processes.

### (Operation and effect)

In the proximity sensor 530, the detection coil unit 210 is sealed by the thermosetting resin portion 121. For example, an epoxy resin is used as the thermosetting resin portion 121. The core body 40 of the detection coil unit 210 includes the burned material such as ferrite. Assuming that the detection coil unit 210 is sealed by the thermoplastic resin portion, the externally-applied stress easily changes with time in the core body 40 and the electromagnetic coil 36, which constitute the detection coil unit 210. The intensity (magnetic flux density) of the magnetic field formed by the core body 40 and the electromagnetic coil 36 becomes easily unstable when the externally-applied stress increases or decreases. Specifically, when the stress applied to the core body 40 changes, the magnetic property of the core body 40 changes due to the influence of the magnetoelastic coupling (the magnetic striction). When the stress applied to the core body 40 changes, the magnetic domain constituting the core body 40 changes, thereby changing the magnetic flux. When the stress applied to the core body 40 changes, sometimes the coil diameter or the distance between the coil wires changes. In this case, the L value or the C value of the coil changes. The fluctuation of the property leads to the fluctuation of detection sensitivity of the proximity sensor.

In the second embodiment, when the thermosetting resin is used as the resin sealing the detection coil unit 210, the stress applied to the detection coil unit 210 is stabilized for a long term compared with the use of the thermoplastic resin. For example, the stress applied to the detection coil unit 210 from the thermosetting resin portion 121 hardly changes immediately after the production of the proximity sensor 530, after the inspection of the proximity sensor 530, after the product shipment of the proximity sensor 530, and during the use of the proximity sensor 530. The proximity sensor 530 can detect the approach or presence of the detection target with stable sensitivity.

On the other hand, the printed board 50 is sealed by the thermoplastic resin portion 122. The resin having a hardness (Shore D) of 60 or less is used as the thermoplastic resin portion 122. The stress remaining in the electronic device after the sealing can be relaxed in the case that the sealing is performed using the low Shore D hardness thermoplastic resin. Even if the printed board 50 is sealed using the thermoplastic resin portion 122, the stress applied to the printed board 50 after the sealing is smaller compared with the case that the printed board 50 is sealed using the thermosetting resin portion 121. According to the proximity sensor 530, the stress applied to the printed board 50 and the electronic components mounted on the printed board 50 can be relaxed.

The proximity sensor 530 is sealed using the thermosetting resin portion 121 and the thermoplastic resin portion 122. The proximity sensor 530 can be produced in a shorter production time compared with the case that the inside of the proximity sensor is wholly sealed using the thermosetting resin portion.

As described above, the viscosity of the thermoplastic resin portion 122 ranges preferably from 500 mPa•s to 10000 mPa•s when being measured with the rheometer AR2000EX (the product of TA Instruments Japan Inc.) at a shearing speed of 10 (1/s) and at a temperature of 190°C. The viscosity of the thermoplastic resin portion 122 ranges more preferably from 500 mPa•s to 8000 mPa•s when being measured with the rheometer AR2000EX (the product of TA Instruments Japan Inc.) at a shearing speed of 10 (1/s) and at a temperature of 190°C. According to the configurations, the thermoplastic resin portion 122 can well adhere to the thermosetting resin portion 121 at the interface between the thermosetting resin portion 121 and the thermoplastic resin portion 122.

Referring to Fig. 56, it is assumed that the flow control member 66 is not provided in the proximity sensor. In this case, the thermoplastic resin injected in order to form the thermoplastic resin portion 122 shrinks as indicated by white arrows in Fig. 56 after the filling. A shrinkage amount of the thermoplastic resin is larger compared with the case that the flow control member 66 is provided in the proximity sensor. In the case that the flow control member 66 is not provided in the proximity sensor, the large stress is generated in association with the shrinkage, air is easily sucked in the proximity sensor from the fitting portion (the fitting portion between the base metallic part and the ring cord and the fitting portion between the base metallic part and the front cover) in association with the shrinkage of the resin, and the air bubble remains easily in the neighborhood of the fitting portion. In the case that air bubbles F1 to F3 remain in the proximity sensor, water is permitted to easily invade from the outside and therefore water-resistant performance is degraded.

It is assumed that the proximity sensor is placed in a high-temperature environment (for example, 70°C) in the case that the flow control member 66 is not provided in the proximity sensor. The thermoplastic resin portion 122 swells as indicated by black arrows in Fig. 56. The swelling amount of the thermoplastic resin portion 122 is larger compared with the case that the flow control member 66 is provided in the proximity sensor. In the case that the flow control member 66 is not provided in the proximity sensor, the large stress is generated in association with the swelling, the swelling of the resin deforms the end surface of the front cover 20 or generates the unnecessary gap in the fitting portion, and therefore the water-resistant performance is degraded. Sometimes the detection sensitivity is degraded when the end surface of the front cover 20 is deformed.

In the case that the flow control member 66 is provided in the proximity sensor like the proximity sensor 530, even if the thermoplastic resin injected in order to form the thermoplastic resin portion 122 shrinks after the filling, the shrinkage amount of the thermoplastic resin is smaller compared with the case that the flow control member 66 is not provided in the proximity sensor. The suction of the air from the fitting portion into the proximity sensor is suppressed or prevented, and the high water-resistant performance can be obtained.

In the case that the flow control member 66 is provided in the proximity sensor like the proximity sensor 530, the swelling amount is smaller even if the proximity sensor 530 is placed in the high-temperature environment (for example, 70°C). The stress generated in association with the swelling is small, the deformation of the end surface of the front cover 20 or the generation of the unnecessary gap in the fitting portion is suppressed or prevented, and the high water-resistant performance can be obtained. The deformation of the end surface of the front cover 20 is suppressed, and the detection sensitivity is hardly degraded due to the deformation of the end surface of the front cover 20.

As described above, in the proximity sensor 530, the sectional shapes of the external flow path (the first flow path) and the internal flow path 66G (the second flow path) are formed such that the resin flowing in and filling the external flow path through the gate 81 reaches the second opening 66b earlier than the resin flowing in and filling the internal flow path 66G through the gate 81. In the second embodiment, the sealing resin 120 (the thermoplastic resin portion 122A) formed between the inner surface 310k of the case member (the base metallic part 60) and the outer surface 66n of the flow control member 66 has the thickness of 2 mm to 4 mm, and a relationship of A : B = 3 to 37 : 1 holds for the first sectional shape of one of or all the positions in the extending direction of the flow control member 66. The area A is an area of the sealing resin 120 (the thermoplastic resin portion 122A) formed between the inner surface 310k of the case member (the base metallic part 60) and the outer surface 66n of the flow control member 66 in the first sectional shape when the sectional shape orthogonal to the extending direction of the flow control member 66 (in the second embodiment, the extending direction of the center axis 102) is set to the first sectional shape. The area B is an area of the sealing resin 120 (the thermoplastic resin portion 122B) formed on the inside (the internal flow path 66G) of the flow control member 66 in the first sectional shape. During the flow, the thermoplastic resin injected through the gate 81 (see Figs. 29 and 32) in order to form the thermoplastic resin portion 122 is branched into the resin flowing into the internal flow path 66G of the flow control member 66 and the resin flowing into the outside of the flow control member 66.

Referring to Fig. 57, it is assumed that the sectional shapes of the external flow path (the first flow path) and the internal flow path 66G (the second flow path) are formed such that the resin flowing in and filling the external flow path through the gate 81 reaches the second opening 66b earlier than the resin flowing in and filling the internal flow path 66G through the gate 81. This is the case that the relationship of A: B = 3 to 37 : 1 does not hold. Assuming that the thermoplastic resin portion 122B formed in the internal flow path 66G of the flow control member 66 has the area of 1, the thermoplastic resin portion 122A formed outside the flow control member 66 has the area (the area ratio) less than 3. In this case, the flow path cross-section area of the internal flow path 66G is smaller than that outside the flow control member 66 in the area ratio. The thermoplastic resin injected through the gate 81 (see Figs. 29 and 32) in order to form the thermoplastic resin portion 122 flows fast not only the outside of the flow control member 66 but also the inside of the internal flow path 66G. During the filling, the thermoplastic resin flows as indicated by white arrows in Fig. 57.

In the case that the relationship of A: B = 3 to 37 : 1 does not hold, the thermoplastic resin flows fast also in the internal flow path 66G to easily push the air to the neighborhood of the fitting portion in which the front cover 20 is fitted in the base metallic part 60. The air bubble that cannot move due to the compression force of the filling pressure remains easily at a spot where the branched resins finally join together. In the case that air bubbles F4 and F5 remain in the neighborhood of the fitting portion, the water is permitted to invade from the outside, which leads to a variation in the water-resistant performance or the degradation in the water-resistant performance.

In the proximity sensor 530, the sealing resin 120 (the thermoplastic resin portion 122A) formed between the inner surface 310k of the case member (the base metallic part 60) and the outer surface 66n of the flow control member 66 has the thickness of 2 mm to 4 mm, and the relationship of A : B = 3 to 37 : 1 holds. In this case, fluidity of the thermoplastic resin can be obtained while an injection volume of the thermoplastic resin is suppressed, the thermoplastic resin injected through the gate 81 (see Figs. 29 and 32) flows fast in the outside of the flow control member 66, and the thermoplastic resin flows slow in the internal flow path 66G. The resin flowing in and filling the external flow path through the gate 81 reaches the second opening 66b earlier than the resin flowing in and filling the internal flow path 66G through the gate 81. Because the flow rate is faster on the outside, the air is hardly pushed to the neighborhood of the fitting portion in which the front cover 20 is fitted in the base metallic part 60. The remaining air bubble is suppressed in the spot (the neighborhood of the fitting portion) where the branched resins finally join together. According to the proximity sensor 530, the variation in the water-resistant performance or the degradation in the water-resistant performance can be suppressed.

Referring to Fig. 58 (and Fig. 41), as described above, the internal flow path 66G includes the first internal flow path 66G1 and the second internal flow path 66G2. The second internal flow path 66G2 has the flow path cross-section area larger than that of the first internal flow path 66G1. The sectional shape which is orthogonal to the extending direction of the second internal flow path 66G2 (in the second embodiment, the extending direction of the center axis 102) and includes a portion in which the second internal flow path 66G2 is provided is referred to as a second sectional shape. In the second embodiment, the shape illustrated in Fig. 41 is obtained as the second sectional shape.

In the second sectional shape, it is assumed that C is an area of the sealing resin 120 (a thermoplastic resin portion 122C in Fig. 41) formed in the first flow path or the external flow path between the inner surface 310k of the case member (the base metallic part 60) and the outer surface 66n of the flow control member 66. In the second sectional shape, it is assumed that D is an area of the sealing resin 120 (a thermoplastic resin portion 122D in Fig. 41) formed inside the second internal flow path 66G2 (the second flow path).

Preferably, a relationship of C : D = 1 to 7 : 1 holds with respect to the second sectional shape at one of or all the positions in the extending direction of the second internal flow path 66G2. In other words, assuming that the thermoplastic resin portion 122D formed in the second internal flow path 66G2 of the flow control member 66 has the area of 1, the thermoplastic resin portion 122D formed outside the flow control member 66 has the area (the area ratio) of 1 to 7. In the proximity sensor 530 of the second embodiment, the relationship of C : D = 1 to 7 : 1 holds, and a step is formed between the second internal flow path 66G2 and the first internal flow path 66G1.

In the case that the relationship of C : D = 1 to 7 : 1 holds, the thermoplastic resin injected through the gate 81 (see Figs. 29 and 32) flows as indicated by the white arrows in Fig. 58 during the injection, and the thermoplastic resin easily invades in the internal flow path 66G from the side of the second opening 66b. The air is more easily pushed into the internal flow path 66G (the second internal flow path 66G2) than into the neighborhood of the fitting portion in which the front cover 20 is fitted in the base metallic part 60. The length L66G2 of the second internal flow path 66G2 ranges from 10% to 70% with respect to the length L66 (see Figs. 36 and 38) between the first opening 66a and the second opening 66b, which allows the higher effect to be obtained. According to the proximity sensor 530, the remaining air bubble in the neighborhood of the fitting portion is suppressed, and the variation in the water-resistant performance or the degradation in the water-resistant performance can further be suppressed.

### (Modification)

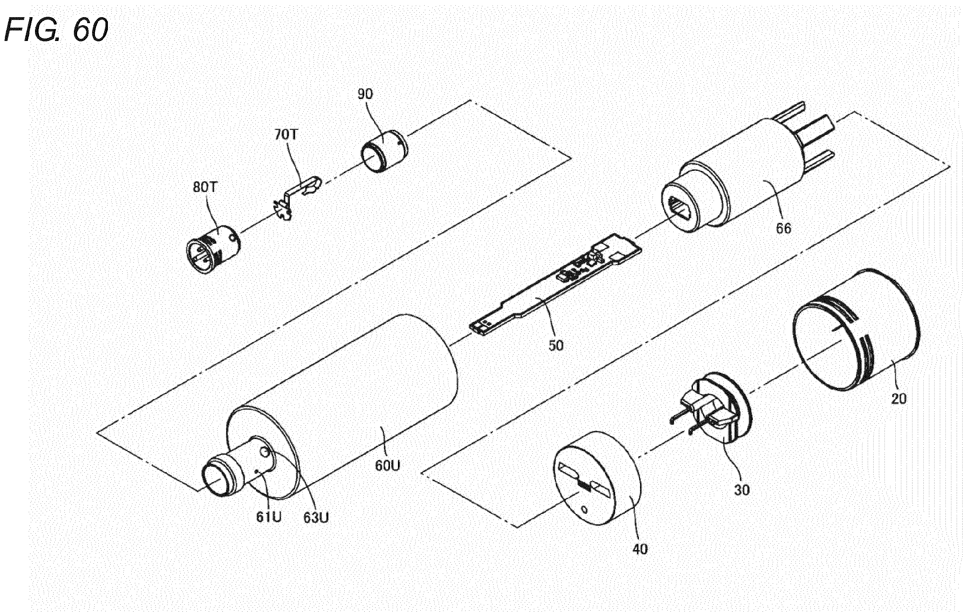

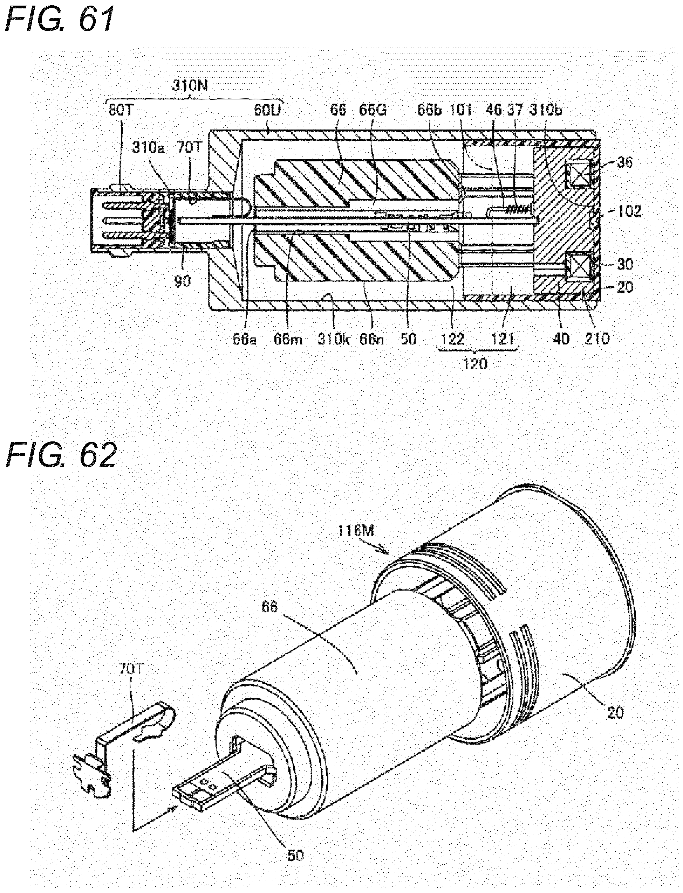

A proximity sensor 540 according to a modification of the proximity sensor 530 (see Fig. 29) will be described with reference to Figs. 59 to 61. In the modification, only a difference between the proximity sensor 530 and the proximity sensor 540 is described, but the overlapping description is neglected. Fig. 59 is a perspective view illustrating the proximity sensor 540. Fig. 60 is an exploded perspective view illustrating the proximity sensor 540. Fig. 61 is a sectional view taken on a line LXI-LXI in Fig. 59.

Referring to Figs. 59 to 61, the proximity sensor 540 includes the detection coil unit 210 (see Fig. 61), the front cover 20, the printed board 50 (see Figs. 60 and 61), a base metallic part 60U, the flow control member 66, the harness 70T, the receptacle 80T, and the light emitting unit cover 90. The proximity sensor 530 are substantially identical to the proximity sensor 540 in the configurations of the detection coil unit 210, the front cover 20, the printed board 50, and the flow control member 66.

The base metallic part 60U is provided as the body case in which the electronic components such as the transistor, the diode, the resistor, and the capacitor are accommodated. The base metallic part 60U constitutes the outline of the proximity sensor 540 on the outer circumference of the center axis 102. The base metallic part 60U has the cylindrical shape that extends with the center axis 102 as the center. The base metallic part 60U extending along the center axis 102 is opened at both the ends. The front cover 20 is inserted in one of the opened ends of the base metallic part 60U, whereby the front cover 20 is fixed to the base metallic part 60U. For example, the base metallic part 60U has an inner diameter of at least 5 mm.

The base metallic part 60U is made of metal. A thread to be used to fix the proximity sensor 540 to the external facility is formed on the outer circumferential surface of the base metallic part 60U. A visible window 63U is formed in the base metallic part 60U as the opening that is used to visibly recognize the emission of the light emitting diode (not illustrated) mounted on the printed board 50. A gate 61U is also formed in the base metallic part 60U. The gate 61U is provided as a through-hole through which the resin is injected into the cylindrical case 310N in producing the proximity sensor 540.

The proximity sensor 540 of the modification is what is called a sealed type proximity sensor in which the base metallic part 60U is disposed on the outer circumference of the detection coil unit 210. The proximity sensor 540 may be applied to what is called a non-sealed type proximity sensor in which the base metallic part 60U is disposed at the position deviated in the axial direction of the center axis 102 from the outer circumference of the detection coil unit 210.

The light emitting unit cover 90 has the cylindrical shape and is inserted (press-fitted) in the base metallic part 60U. The light emitting unit cover 90 is made of resin. The light emitting unit cover 90 is made of a transparent or translucent resin such that the emission of the light emitting diode is visibly recognized from the outside of the proximity sensor 540. The light emitting unit cover 90 is disposed so as to be oriented toward the light emitting diode on the printed board 50, and the light emitting unit cover 90 is provided so as to close the visible window 63U. Because of the light emitting unit cover 90, the sealing resin 120 with which the base metallic part 60U is filled is not exposed to the external space through the visible window 63U.

The light emitting unit cover 90 is provided so as to be able to be inserted from the opened end of the base metallic part 60U. The light emitting unit cover 90 is not integral with the base metallic part 60U because of outsert molding, but the light emitting unit cover 90 is provided so as to be able to separate from the base metallic part 60U. In the proximity sensor 540, the thermoplastic resin is used as the resin sealing the electronic components in the base metallic part 60U. The thermoplastic resin exerts the low fluidity in filling the base metallic part 60U with the resin. Because the resin hardly flows between the inner circumferential surface of the base metallic part 60U and the light emitting unit cover 90, it is not necessary to adopt the outsert molding that is of a technique of bringing the inner circumferential surface of the base metallic part 60U and the light emitting unit cover 90 into close contact with each other. The configurations of the light emitting unit cover 90 and the base metallic part 60U are simplified to be able to reduce a production cost of the proximity sensor 540.

The receptacle 80T is provided so as to close the opened end on the rear end side of the cylindrical base metallic part 60U. The receptacle 80T is provided as the connector cover including a pin that connects the proximity sensor 540 to the outside. The receptacle 80T extends cylindrically with the center axis 102 as the center while being integral with the base metallic part 60U. The base metallic part 60U and the receptacle 80T constitute the cylindrical case 310N that extends cylindrically with the center axis 102 as the center. The printed board 50 and the electronic components mounted on the printed board 50 are accommodated in the cylindrical case 310N.

The harness 70T is the flexible wiring member. The harness 70T is provided in the base metallic part 60U as the wiring member that electrically connects the printed board 50 and the pin of the receptacle 80T. The harness 70T is connected to the pin of the receptacle 80T and the printed board 50 by the soldering.

### (Sealing resin 120)

In the cylindrical case 310N, the sealing resin 120 is formed by the injection of the resin. In the proximity sensor 540, the tubular case member in which the detection coil unit 210 and the printed board 50 are accommodated is constructed by the cylindrical case 310N, the receptacle 80T, and the front cover 20. The inner surface 310k of the case member includes the inner surface of the base metallic part 60, the inner surface of the receptacle 80T, and the inner surface of the front cover 20. The first end portion 310a is formed in the inner surface 310k on the side of the receptacle 80T, and the second end portion 310b is formed in the inner surface 310k on the side of the front cover 20.

The first end portion 310a is located at the circumferential edge of the opening in which the pin is attached in the inner surface of the receptacle 80T. In the inner surface of the front cover 20, the second end portion 310b is located in the front in the insertion direction of the core body 40. The second end portion 310b that is of the case member is closed by the front cover 20. The inner surface 310k of the case member in which the detection coil unit 210 and the printed board 50 are accommodated has the shape extending from the first end portion 310a toward the second end portion 310b (or the shape extending from the second end portion 310b toward the first end portion 310a).

The sealing resin 120 is provided such that the space of the case member surrounded by the cylindrical case 310N and the front cover 20 and the receptacle 80T, which close the front and rear ends of the cylindrical case 310N, is filled with the sealing resin 120. The sealing resin 120 seals the detection coil unit 210 accommodated in the front cover 20 and the printed board 50 and electronic components which are accommodated in the cylindrical case 310N.

The sealing resin 120 includes the thermosetting resin portion 121 and the thermoplastic resin portion 122. The thermosetting resin portion 121 is made of a thermosetting resin, and seals the detection coil unit 210 (the core body 40, the electromagnetic coil 36, and the coil spool 30). The thermoplastic resin portion 122 is made of a thermoplastic resin, and formed in the portion other than the thermosetting resin portion 121 in the case member (the cylindrical case 310N, the receptacle 80T, and the front cover 20) to seal the printed board 50 and the electronic components. The thermoplastic resin having a hardness (Shore D) of 60 or less is selected to form the thermoplastic resin portion 122. The thermoplastic resin portion 122 is formed by the solidification of the thermoplastic resin injected through the gate 61U after the thermoplastic resin flows in the flow path (the first flow path or the external flow path) formed between the inner surface 310k of the case member and the outer surface 66n of the flow control member 66 and spreads in the internal flow path 66G (the second flow path) constructed by the tubular internal space of the flow control member 66.

The thermosetting resin portion 121 and the thermoplastic resin portion 122 are provided so as to have the boundary in the front cover 20 indicated by the alternate long and two short dashes line 101 in Fig. 61. The thermosetting resin portion 121 seals part of the coil pin 46 (portion on the root side of the coil pin 46) while sealing at least the core body 40, the electromagnetic coil 36, and the coil spool 30. In the coil pin 46, the portion that is not sealed by the thermosetting resin portion 121 is sealed by the thermoplastic resin portion 122. In the coil pin 46, the portion extending from the front of the portion around which the leading end 37 of the electromagnetic coil 36 (the coil wire) is wound is sealed by the thermoplastic resin portion 122.

In the coil pin 46, the portion soldered to the pattern of the printed board 50 is sealed by the thermoplastic resin portion 122. Alternatively, in the coil pin 46, the portion extending from the front of the portion around which the leading end 37 of the electromagnetic coil 36 (the coil wire) is wound may be sealed by the thermosetting resin portion 121. In this case, in the coil pin 46, the portion soldered to the pattern of the printed board 50 is sealed by the thermosetting resin portion 121.

The thermoplastic resin that can be molded at low temperature and at low pressure is suitably used to form the thermoplastic resin portion 122. At least one selected from a group consisting of polyolefin, polyester, and polyamide can be cited as an example of the thermoplastic resin. Various additives such as a flame retardant, an organic/inorganic filler, a plasticizer, a colorant, and an antioxidant may be contained in the thermoplastic resin used to form the thermoplastic resin portion 122. The use of the thermoplastic resin having a hardness (Shore D) of 60 or less can reduce the stress applied to the internal device due to the heat and the pressure during the filling of the resin, eliminate the necessity for the reaction curing, and shorten the process tact time.

An epoxy resin can be cited as a typical example of the thermosetting resin used to form the thermosetting resin portion 121. Preferably the thermosetting resin portion 121 has the small fluctuation in resin stress (the stress relaxation) applied to the detection coil unit 210. Preferably the thermosetting resin portion 121 has an elastic modulus of 800 MPa or more at room temperature. Various additives such as a flame retardant, an organic/inorganic filler, a plasticizer, a colorant, and an antioxidant may be contained in the thermosetting resin used to form the thermosetting resin portion 121. The sealing resin 120 is not limited to the two-stage segmentation structure including the thermosetting resin portion 121 and the thermoplastic resin portion 122, but the sealing resin 120 may have a segmentation structure of at least three stages.

The viscosity of the thermoplastic resin portion 122 ranges preferably from 500 mPa•s to 10000 mPa•s when being measured with the rheometer AR2000EX (the product of TA Instruments Japan Inc.) at a shearing speed of 10 (1/s) and at a temperature of 190°C. The viscosity of the thermoplastic resin portion 122 ranges more preferably from 500 mPa•s to 8000 mPa•s when being measured with the rheometer AR2000EX (the product of TA Instruments Japan Inc.) at a shearing speed of 10 (1/s) and at a temperature of 190°C.

### (Producing method)

A method for producing the proximity sensor 540 (see Fig. 59) will be described with reference to Figs. 62 to 64. Referring to Fig. 62, the sub-assembly 116M including the detection coil unit 210 and the printed board 50 is assembled (similarly to the case described with reference to Fig. 50). Then the front cover 20 and the flow control member 66 are assembled in the sub-assembly 116M (similarly to the case described with reference to Fig. 51).

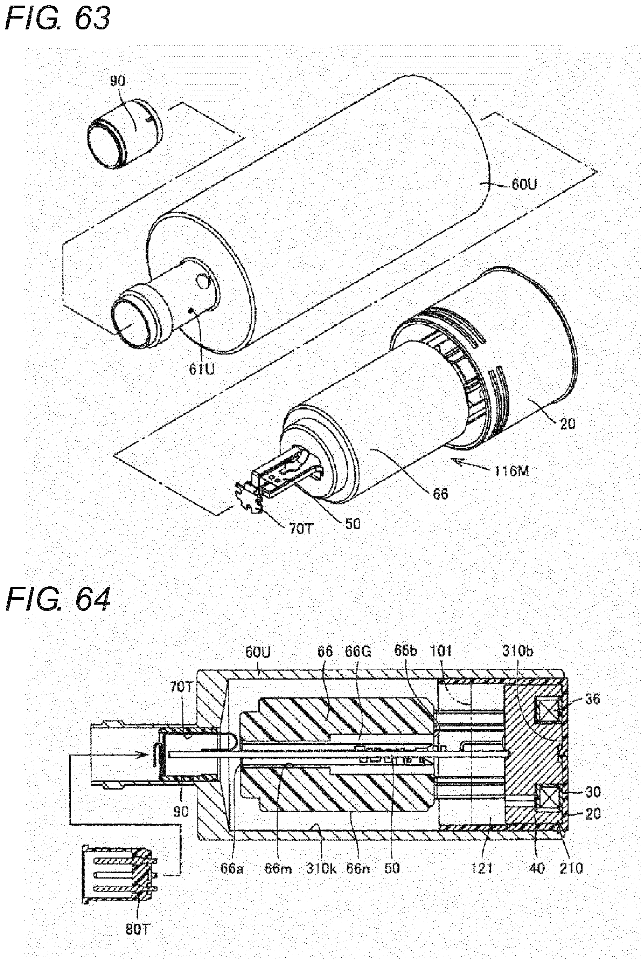

Then the harness 70T is assembled in the sub-assembly 116M. Specifically, the harness 70T is soldered onto the surface of the printed board 50. Referring to Fig. 63, the base metallic part 60U is assembled in the front cover 20. Specifically, the harness 70T and the printed board 50 are sequentially inserted from the front end side of the base metallic part 60U, and the front cover 20 is press-fitted in the front end side of the base metallic part 60U. Then the light emitting unit cover 90 is press-fitted in the base metallic part 60U from the opening on the rear end side of the base metallic part 60U.

Referring to Fig. 64, the receptacle 80T is assembled in the base metallic part 60U. Specifically, the receptacle 80T is press-fitted in the rear end side of the base metallic part 60U. Then the base metallic part 60 and the receptacle 80T are fixed to each other using fixing methods such as the gouging, the swaging, the adhesion, and the welding. The process of fixing the base metallic part 60U and the receptacle 80T to each other may be performed after the process of filling the proximity sensor with a secondary filling resin subsequent thereto.

Then the cylindrical case 310N (see Fig. 61) including the base metallic part 60U and the receptacle 80T is filled with the thermoplastic resin as the secondary filling resin. More specifically, the assembly obtained through the process is set in the die using the positioning jig. The high-temperature resin is injected into the cylindrical case 310N through the gate 61U (see Fig. 59). The gate 61U is provided on the side (between the first end portion 310a and the first opening 66a of the flow control member 66) of the first end portion 310a from the portion in which the first opening 66a of the flow control member 66 is located in the extending direction of the center axis 102. The high-temperature resin is branched into the resin flowing into the internal flow path 66G (the second flow path) of the flow control member 66 from the side of the first end portion 310a and the resin flowing into the external flow path or the first flow path between the outer surface 66n of the flow control member 66 and the inner surface 310k of the case member. The branched resins finally join together in the neighborhood of the front cover 20, and the internal space of the case member is substantially filled with the resin while an air bubble is confined in the resin. The resin flowing in and filling the external flow path through the gate 61U reaches the second opening 66b earlier than the resin flowing in and filling the internal flow path 66G through the gate 61U. The thermoplastic resin portion 122 (see Fig. 61) is formed by cooling and solidifying the thermoplastic resin. The printed board 50 and various electronic components in the cylindrical case 310N are sealed by the resin. The proximity sensor 540 in Fig. 59 is completed through the above processes.

### (Operation and effect)

In the proximity sensor 540, similarly the detection coil unit 210 is sealed by the thermosetting resin portion 121. The stress applied to the detection coil unit 210 is stabilized for a long term compared with the case that the detection coil unit 210 is sealed using the thermoplastic resin portion. The proximity sensor 540 can detect the approach or presence of the detection target with the stable sensitivity.

On the other hand, the printed board 50 is sealed by the thermoplastic resin portion 122. The resin having a hardness (Shore D) of 60 or less is used as the thermoplastic resin portion 122. According to the proximity sensor 540, similarly the stress applied to the printed board 50 and the electronic components mounted on the printed board 50 can be relaxed. The proximity sensor 540 can be produced in a shorter production time compared with the case that the inside of the proximity sensor is wholly sealed using the thermosetting resin portion.

In the case that the flow control member 66 is provided in the proximity sensor like the proximity sensor 540, even if the thermoplastic resin injected in order to form the thermoplastic resin portion 122 shrinks after the filling, the shrinkage amount of the thermoplastic resin is smaller compared with the case that the flow control member 66 is not provided in the proximity sensor. The suction of the air from the fitting portion into the proximity sensor is suppressed or prevented, and the high water-resistant performance can be obtained.

In the case that the flow control member 66 is provided in the proximity sensor like the proximity sensor 540, the swelling amount is smaller even if the proximity sensor 540 is placed in the high-temperature environment (for example, 70°C). The stress generated in association with the swelling is small, the deformation of the end surface of the front cover 20 or the generation of the unnecessary gap in the fitting portion is suppressed or prevented, and the high water-resistant performance can be obtained. The deformation of the end surface of the front cover 20 is suppressed, and the detection sensitivity is hardly degraded due to the deformation of the end surface of the front cover 20.

In the proximity sensor 540, the sectional shapes of the external flow path (the first flow path) and the internal flow path 66G (the second flow path) are formed such that the resin flowing in and filling the external flow path through the gate 61U reaches the second opening 66b earlier than the resin flowing in and filling the internal flow path 66G through the gate 61U. In the second embodiment, the sealing resin 120 (the thermoplastic resin portion 122) formed between the inner surface 310k of the case member (the base metallic part 60U) and the outer surface 66n of the flow control member 66 has the thickness of 2 mm to 4 mm, and the relationship of A : B = 3 to 37 : 1 holds for the first sectional shape of one of or all the positions in the extending direction of the flow control member 66. The resin flowing in and filling the external flow path through the gate 61U reaches the second opening 66b earlier than the resin flowing in and filling the internal flow path 66G through the gate 61U. The fluidity of the thermoplastic resin can be obtained while the injection volume of the thermoplastic resin is suppressed, the thermoplastic resin injected through the gate 61U flows fast in the outside of the flow control member 66, and the thermoplastic resin flows slow in the internal flow path 66G. Because the flow rate is faster on the outside, the air is hardly pushed to the neighborhood of the fitting portion in which the front cover 20 is fitted in the base metallic part 60U. The remaining air bubble is suppressed in the spot (the neighborhood of the fitting portion) where the branched resins finally join together. According to the proximity sensor 540, the variation in the water-resistant performance or the degradation in the water-resistant performance can be suppressed.

Preferably, similarly to the proximity sensor 530, the relationship of C : D = 1 to 7 : 1 holds with respect to the second sectional shape at one of or all the positions in the extending direction of the second internal flow path 66G2. The thermoplastic resin injected through the gate 61U invades easily into the internal flow path 66G from the side of the second opening 66b. The remaining air bubble in the neighborhood of the fitting portion is suppressed, and the variation in the water-resistant performance or the degradation in the water-resistant performance can further be suppressed.

In the embodiments, the proximity sensor is described as an example of the electronic device. However, the present invention is not limited to the proximity sensor. For example, the present invention may be applied to a photoelectric sensor, a fiber sensor, and a smart sensor.

The photoelectric sensor detects the presence or non-presence of the object or a change in surface state using various characters of the light emitted from the light emitting source. The detection unit of the photoelectric sensor includes a light emitting diode or a semiconductor laser, which is of the light emitting source. The fiber sensor is one in which an optical fiber is combined with the photoelectric sensor. The detection unit of the fiber sensor also includes the light emitting diode or the semiconductor laser, which is of the light emitting source. The smart sensor is one in which an analysis capacity or an information processing capacity is added to the proximity sensor or the photoelectric sensor. The detection unit of the smart sensor corresponds to the detection coil unit of the embodiment when the proximity sensor is used as the basic configuration, and the detection unit of the smart sensor includes the light emitting diode or the semiconductor laser, which is of the light emitting source, when the photoelectric sensor is used as the basic configuration.

Although the embodiment and Examples of the present invention are described above, the disclosed embodiment and Examples are not restrictive but illustrative only. The technical scope of the present invention is defined by the claims.

The present invention can be applied to the electronic device including the detection unit that detects the approach or presence of the detection target.

## Claims

1. An electronic device (510, 520, 530, 540) comprising:
a detection unit (210) configured to detect the approach or presence of a detection target;
an electronic component that is electrically connected to the detection unit (210);
a case member (60, 60T, 60U) configured to accommodate the detection unit (210) and the electronic component therein; and
a sealing resin (120) that is formed in the case member (60, 60T, 60U),
wherein the sealing resin (120) comprises:
a thermosetting resin portion (121) that is formed in the case member (60, 60T, 60U) so as to seal the detection unit (210); **characterised by**
a thermoplastic resin portion (122) that is formed in a portion other than the thermosetting resin portion (121) in the case member (60, 60T, 60U) so as to seal the electronic component, the thermoplastic resin portion (122) having a Shore D hardness of 60 or less.

2. The electronic device (510, 520, 530, 540) according to claim 1, wherein
the detection unit (210) comprises a coil (210) in which a coil wire (36) is wound around a spool body (30) and a core body (40) configured to accommodate the coil (210) therein, and
the thermosetting resin portion (121) seals the coil (210) and the core body (40).

3. The electronic device (510, 520, 530, 540) according to claim 2, further comprising a coil case (20) that is accommodated at one end of the case member (60, 60T, 60U),
wherein the core body (40) is accommodated in the coil case (20), and
the thermosetting resin portion (121) is formed in the coil case (20).

4. The electronic device (510, 520, 530, 540) according to any of claims 1 to 3, wherein
the case member (60, 60T, 60U) has a cylindrical shape in which an inner diameter is greater than or equal to 5 mm and accommodates an elongated board (50) on which the electronic component is mounted, and
the viscosity of the thermoplastic resin portion (122) ranges from 500 mPa•s to 10000 mPa•s when being measured with a rheometer at a shearing speed of 10 (1/s) and at a temperature of 190°C.

5. The electronic device (510, 520, 530, 540) according to any of claims 1 to 4, wherein the viscosity of the thermoplastic resin portion (122) ranges from 500 mPa•s to 8000 mPa•s when being measured with the rheometer at a shearing speed of 10 (1/s) and at a temperature of 190°C.

6. An electronic device producing method comprising the steps of:
disposing a detection unit (210) and an electronic component in a case member (60, 60T, 60U), the detection unit (210) being configured to detect the approach or presence of a detection target, the electronic component being electrically connected to the detection unit (210);
forming a thermosetting resin portion (121) such that the detection unit (210) is sealed in the case member (60, 60T, 60U) **characterised in that** a thermoplastic resin portion (122) having a Shore D hardness of 60 or less is formed in a portion other than the thermosetting resin portion (121) in the case member (60, 60T, 60U) so as to seal the electronic component.

## Patentansprüche

1. Elektronische Vorrichtung (510, 520, 530, 540), welche aufweist:
eine Erfassungseinheit (210), die eingerichtet ist, die Annäherung oder das Vorliegen eines Erfassungsziels zu erfassen;
eine elektronische Komponente, die elektrisch mit der Erfassungseinheit (210) verbunden ist;
ein Gehäuseelement (60, 60T, 60U), das eingerichtet ist, die Erfassungseinheit (210) und die elektronische Komponente darin aufzunehmen; und
ein dichtender Kunststoff (120), der in dem Gehäuseelement (60, 60T, 60U) gebildet ist,
wobei der dichtende Kunststoff (120) aufweist:
einen wärmehärtenden Kunststoffabschnitt (121), der in dem Gehäuseelement (60, 60T, 60U) gebildet ist, um die Erfassungseinheit (210) abzudichten;
**gekennzeichnet durch**
einen thermoplastischen Kunststoffabschnitt (122), der in einem Abschnitt in dem Gehäuseelement (60, 60T, 60U) gebildet ist, der verschieden von dem wärmehärtenden Kunststoffabschnitt (121) ist, um die elektronische Komponente abzudichten, wobei der thermoplastischen Kunststoffabschnitt (122) eine Shore D Härte von 60 oder weniger aufweist.

2. Elektronische Vorrichtung (510, 520, 530, 540) gemäß Anspruch 1, wobei
die Erfassungseinheit (210) eine Spule (210) aufweist, in welcher ein Spulendraht (36) um einen Rollenkörper (30) und einen Kernkörper (40), der eingerichtet ist, die Spule (210) darin aufzunehmen, gewickelt ist, und
der wärmehärtende Kunststoffabschnitt (121) die Spule (210) und den Kernkörper (40) abgedichtet.

3. Elektronische Vorrichtung (510, 520, 530, 540) gemäß Anspruch 2, welche ferner ein Spulengehäuse (20) aufweist, das an einem Ende des Gehäuseelements (60, 60T, 60U) aufgenommen ist,
wobei der Kernkörper (40) in dem Spulengehäuse (20) aufgenommen ist, und
der wärmehärtende Kunststoffabschnitt (121) in dem Spulengehäuse (20) gebildet ist.

4. Elektronische Vorrichtung (510, 520, 530, 540) gemäß einem der Ansprüche 1 bis 3, wobei
das Gehäuseelement (60, 60T, 60U) eine zylindrische Form hat, in welcher ein Innendurchmesser größer oder gleich 5 mm ist und eine längliche Platine (50) aufnimmt, auf welche die elektronische Komponente montiert ist, und
die Viskosität des thermoplastischen Kunststoffabschnitts (122) von 500 mP·s bis 10000 mPa·s reicht, wenn sie mit einem Rheometer mit einer Schergeschwindigkeit von 10 (1/s) und bei einer Temperatur 190 °C gemessen wird.

5. Elektronische Vorrichtung (510, 520, 530, 540) gemäß einem der Ansprüche 1 bis 4, wobei die Viskosität des thermoplastischen Kunststoffabschnitts (122) von 500 mP·s bis 8000 mPa·s reicht, wenn sie mit einem Rheometer mit einer Schergeschwindigkeit von 10 (1/s) und bei einer Temperatur 190 °C gemessen wird.

6. Herstellungsverfahren für eine elektronische Vorrichtung, das die Schritte aufweist von:
Anordnen einer Erfassungseinheit (210) und einer elektronischen Komponente in einem Gehäuseelement (60, 60T, 60U), wobei die Erfassungseinheit (210) eingerichtet ist, die Annäherung oder das Vorliegen eines Erfassungsziels zu erfassen, wobei die elektronische Komponente elektrisch mit der Erfassungseinheit (210) verbunden ist;
Bilden eines wärmehärtenden Kunststoffabschnitts (121), so dass die Erfassungseinheit (210) in dem Gehäuseelement (60, 60T, 60U) abgedichtet wird,
**dadurch gekennzeichnet, dass**
ein thermoplastischer Kunststoffabschnitt (122) mit einer Shore D Härte von 60 oder weniger in einem Abschnitt in dem Gehäuseelement (60, 60T, 60U) gebildet ist, der verschieden von dem wärmehärtenden Kunststoffabschnitt (121) ist, um die elektronische Komponente abzudichten.

## Revendications

1. Dispositif électronique (510, 520, 530, 540), comprenant :
une unité de détection (210) configurée pour détecter l'approche ou la présence d'une cible de détection ;
un composant électronique qui est électriquement connecté à l'unité de détection (210) ;
un élément boîtier (60, 60T, 60U) configuré pour recevoir en son sein l'unité de détection (210) et le composant électronique ; et
une résine de scellement (120) qui est formée dans l'élément boîtier (60, 60T, 60U),
dans lequel la résine de scellement (120) comprend :
une partie de résine thermodurcissable (121) qui est formée dans l'élément boîtier (60, 60T, 60U) de façon à sceller l'unité de détection (210) ; **caractérisé par**
une partie de résine thermoplastique (122) qui est formée dans une partie autre que la partie de résine thermodurcissable (121) dans l'élément boîtier (60, 60T, 60U) de façon à sceller le composant électronique, la partie de résine thermoplastique (122) ayant une dureté Shore D inférieure ou égale à 60.

2. Dispositif électronique (510, 520, 530, 540) selon la revendication 1, dans lequel
l'unité de détection (210) comprend une bobine (210) dans laquelle un fil (36) de bobine est enroulé autour d'un corps de bobine (30) et un corps central (40) configuré pour recevoir la bobine (210) en son sein, et
la partie de résine thermodurcissable (121) scelle la bobine (210) et le corps central (40).

3. Dispositif électronique (510, 520, 530, 540) selon la revendication 2, comprenant en outre un boîtier (20) de bobine qui est reçu au niveau d'une extrémité de l'élément boîtier (60, 60T, 60U),
dans lequel le corps central (40) est reçu dans le boîtier (20) de bobine, et
la partie de résine thermodurcissable (121) est formée dans le boîtier (20) de bobine.

4. Dispositif électronique (510, 520, 530, 540) selon l'une quelconque des revendications 1 à 3, dans lequel
l'élément boîtier (60, 60T, 60U) a une forme cylindrique selon laquelle un diamètre intérieur est supérieur ou égal à 5 mm et reçoit une carte allongée (50) sur laquelle est monté le composant électronique, et
la viscosité de la partie de résine thermoplastique (122) s'inscrit dans une plage de 500 mPa.s à 10 000 mPa.s lorsqu'elle est mesurée au moyen d'un rhéomètre à une vitesse de cisaillement de 10 (1/s) et à une température de 190 °C.

5. Dispositif électronique (510, 520, 530, 540) selon l'une quelconque des revendications 1 à 4, dans lequel la viscosité de la partie de résine thermoplastique (122) s'inscrit dans une plage de 500 mPa.s à 8 000 mPa.s lorsqu'elle est mesurée au moyen du rhéomètre à une vitesse de cisaillement de 10 (1/s) et à une température de 190 °C.

6. Procédé de production de dispositif électronique comprenant les étapes consistant à :
disposer une unité de détection (210) et un composant électronique dans un élément boîtier (60, 60T, 60U), l'unité de détection (210) étant configurée pour détecter l'approche ou la présence d'une cible de détection, le composant électronique étant électriquement connecté à l'unité de détection (210) ;
former une partie de résine thermodurcissable (121) de sorte que l'unité de détection (210) soit scellée dans l'élément boîtier (60, 60T, 60U), **caractérisé en ce que**
une partie de résine thermoplastique (122) ayant une dureté Shore D inférieure ou égale à 60 est formée dans une partie autre que la partie de résine thermodurcissable (121) dans l'élément boîtier (60, 60T, 60U) de façon à sceller le composant électronique.
